# EUROPEAN PATENT APPLICATION

(11) **EP 4 583 340 A1**
(43) Date of publication of application: **09.07.2025**
(21) Application number: 23859790.0
(22) Date of filing: 19.06.2023
(51) Int. Cl.: H02H 7/26, G01R 31/12, H02H 3/05, H02H 11/00, H02J 1/00, H02J 3/38, H02J 7/35

(54) **POWER SUPPLY SYSTEM**

(30) Priority: 02.09.2022 JP 2022140288; 02.09.2022 JP 2022140289; 02.09.2022 JP 2022140290; 06.10.2022 JP 2022161563
(71) Applicant: Kaneka Corporation, Osaka-shi, Osaka 530-8288 (JP)
(72) Inventor: NISHIYAMA, Haruo, Osaka-shi, Osaka 530-8288 (JP)
(74) Representative: Hoffmann Eitle
(86) International application number: PCT/JP2023/022617
(87) International publication number: WO 2024/048020

(57) **Abstract**

The present invention provides a power supply system that can promptly extinguish arc discharge in a case where series arc discharge or parallel arc discharge occurs in a portion closer to a power storage module than to a power conversion device. The power supply system includes a power storage module; a power conversion device; a bidirectional converter portion; and an arc discharge detector, in which the power storage module has a secondary battery, and is connected to the power conversion device via the bidirectional converter portion, the arc discharge detector detects arc discharge inside the power conversion device or in a portion closer to the power storage module than to the power conversion device, and when the arc discharge detector detects the arc discharge, an arc interruption operation of interrupting conduction of power between the power conversion device and the secondary battery is executed.

## Description

### TECHNICAL FIELD

The present invention relates to a power supply system including a power storage module and a power conversion device, and capable of supplying power from the power storage module to a system power supply portion by connecting the system power supply portion to the power conversion device.

### BACKGROUND ART

In recent years, a hybrid power storage system including, in a casing, a DC/DC converter to which a solar cell is connected, a bidirectional DC/DC converter to which a storage battery is connected, and a bidirectional AC/DC inverter connected to a commercial power supply system has been developed (for example, Patent Document 1).

In this hybrid power storage system, the power generated by the solar cell in the daytime can be boosted by the DC/DC converter and stepped down by the bidirectional DC/DC converter to charge the storage battery, and the power stored in the storage battery at night can be boosted by the bidirectional DC/DC converter, converted into AC power by the bidirectional AC/DC inverter, and supplied to the commercial power system.

Therefore, in this hybrid power storage system, power generated by the solar cell can be supplied to the commercial power system day and night.

### PRIOR ART DOCUMENT

### PATENT DOCUMENT

Patent Document 1: JP 2021-93887 A

### DISCLOSURE OF INVENTION

### TECHNICAL PROBLEM

By the way, in the hybrid power generation system of Patent Document 1, a terminal is provided on an outer surface of the casing, and a storage battery or a solar cell is connected to the terminal by a cable. However, in a case where a state in which cable pinching during installation, damage to the cable, or a contact failure of the terminal has occurred and is left as it is, arc discharge may occur due to aging deterioration, and the occurrence of arc discharge may lead to a fire.

The arc discharge can be roughly classified into series arc discharge and parallel arc discharge depending on a place where the arc discharge occurs on the circuit.

The series arc discharge occurs in a case where a current passes through a conductive wire in a series circuit, and the parallel arc discharge occurs in a case where a current passes between two conductive wires connected in parallel in a parallel circuit.

In a case where any arc discharge occurs, it is necessary to extinguish the arc discharge promptly.

Therefore, an object of the present invention is to provide a power supply system that can promptly extinguish the arc discharge in a case where the series arc discharge or the parallel arc discharge occurs in a portion closer to the power storage module than to the power conversion device.

### SOLUTION TO PROBLEM

An aspect of the present invention for solving the above-described problems is a power supply system including a power storage module; a power conversion device; a bidirectional converter portion; and an arc discharge detector, in which the power storage module has a secondary battery, and is connected to the power conversion device via the bidirectional converter portion, the arc discharge detector detects arc discharge in a portion closer to the power storage module than to the power conversion device, and when the arc discharge detector detects the arc discharge, an arc interruption operation of interrupting conduction of power between the power conversion device and the secondary battery is executed.

According to the present aspect, it is possible to promptly extinguish the arc discharge in a case where the series arc discharge occurs in a portion closer to the power storage module than to the power conversion device.

In a preferable aspect, the bidirectional converter portion has a power-storage-side connection part electrically connected to the power storage module, and a conversion-side connection part electrically connected to the power conversion device, the bidirectional converter portion has a step-down circuit in which the power-storage-side connection part, a reactor portion, a second switching element, and the conversion-side connection part are connected in series, and a first rectifying portion is connected in parallel to the reactor portion and the power storage module; and a boost circuit in which the power-storage-side connection part, the reactor portion, a second rectifying portion, and the conversion-side connection part are connected in series, and a first switching element is connected in parallel to the reactor portion and the power storage module, the bidirectional converter portion is capable of executing a step-down operation that steps down an input voltage from the power conversion device by putting the first switching element into an OFF state and switching between an ON state and an OFF state of the second switching element, and outputs power to the power storage module; and a boost operation that boosts the input voltage from the power storage module by putting the second switching element into the OFF state and switching between the ON state and the OFF state of the first switching element, and outputs power to the power conversion device, the power supply system further includes a series arc detector that detects series arc discharge in a portion closer to the power storage module than to the bidirectional converter portion, and when the series arc detector detects series arc discharge, a series arc interruption operation in which following (A) and/or (B) is performed is executed.
(A) Interrupting to input and output power to and from the bidirectional converter portion by a power-storage-side interrupter included in the power storage module.
(B) Keeping the first switching element and the second switching element in the OFF state or putting them into the OFF state and then maintaining.

In a more preferable aspect, the power conversion device has a system-side connection terminal connectable to a system power supply portion, and an inverter portion having an inverter-side interrupter that is capable of interrupting supply of power to the system-side connection terminal side, and the series arc interruption operation performs, in a case where a voltage of the inverter portion exceeds a voltage of the power storage module, at least the (A) or the (B); and performs, in a case where the voltage of the inverter portion is equal to or less than the voltage of the power storage module, at least a combination of the (A) or the (B) and following (C).

(C) Interrupting supply of power to the system-side connection terminal side by the inverter-side interrupter.

A preferable aspect is the power supply system in which the power conversion device has an inverter portion, and a system-side connection terminal connectable to a system power supply portion, the inverter portion includes a third switching element, a fourth switching element, a fifth switching element, and a sixth switching element; and is provided with a full-bridge circuit in which the third switching element and the sixth switching element, and the fourth switching element and the fifth switching element are respectively arranged diagonally, the inverter portion includes a system interrupter that interrupts distribution of power between the full-bridge circuit side and the system-side connection terminal side, the bidirectional converter portion has a power-storage-side connection part electrically connected to the power storage module, and a conversion-side connection part electrically connected to the power conversion device, the bidirectional converter portion has a step-down circuit in which the power-storage-side connection part, a reactor portion, a second switching element, and the conversion-side connection part are connected in series, and a first rectifying portion is connected in parallel to the reactor portion and the power storage module; and a boost circuit in which the power-storage-side connection part, the reactor portion, a second rectifying portion, and the conversion-side connection part are connected in series, and a first switching element is connected in parallel to the reactor portion and the power storage module, the bidirectional converter portion is capable of executing a step-down operation that steps down an input voltage from the power conversion device by putting the first switching element into an OFF state and switching between an ON state and an OFF state of the second switching element, and outputs power to the power storage module; and a boost operation that boosts the input voltage from the power storage module by putting the second switching element into the OFF state and switching between the ON state and the OFF state of the first switching element, and outputs power to the power conversion device, the power supply system further includes a parallel arc detector that detects parallel arc discharge in a portion closer to the power storage module than to the bidirectional converter portion, and when the parallel arc detector detects parallel arc discharge, a parallel arc interruption operation is executed, in the parallel arc interruption operation, the second switching element is kept in an OFF state or is put into the OFF state and then maintained, and at least one of following (D) to (F) is performed.
(D) Interrupting to input and to output power to and from the bidirectional converter portion by a power-storage-side interrupter included in the power storage module.
(E) Keeping the first switching element in the ON state or putting it into the ON state and then maintaining.
(F) Interrupting conduction of power between the full-bridge circuit side and the system-side connection terminal side by the system interrupter, and keeping the third switching element and the fifth switching element and/or the fourth switching element and the sixth switching element in the ON state or putting them into the ON state and then maintaining.

Meanwhile, in some power conversion devices, in order to provide versatility to the power conversion device, there is a case where a power conversion device and a bidirectional converter portion are separately provided and the power conversion device and the bidirectional converter portion are connected by a wiring member such as a cable.

In this manner, the power conversion device can be used together with a solar cell power generation system that does not have a power storage function and does not require a bidirectional converter portion.

However, in this case, also in a portion between the bidirectional converter portion and the power conversion device, there is a case where cable pinching during installation, damage to the cable, or a contact failure of the terminal occurs, and arc discharge may occur at that portion due to aging deterioration.

In a preferable aspect, the power supply system further includes a second parallel arc detector that detects parallel arc discharge in a portion between the bidirectional converter portion and the power conversion device, in which the power conversion device has an inverter portion, and a system-side connection terminal connectable to a system power supply portion, the inverter portion includes a third switching element, a fourth switching element, a fifth switching element, and a sixth switching element; and is provided with a full-bridge circuit in which the third switching element and the sixth switching element, and the fourth switching element and the fifth switching element are respectively arranged diagonally, the inverter portion includes a system interrupter that interrupts distribution of power between the full-bridge circuit side and the system-side connection terminal side, and when the second parallel arc detector detects parallel arc discharge, conduction of power between the full-bridge circuit side and the system-side connection terminal side is interrupted by the system interrupter, and a second parallel arc interruption operation in which at least one of following (G) and (H) is performed is executed.
(G) Keeping the third switching element and the fifth switching element and/or the fourth switching element and the sixth switching element in the ON state or putting them into the ON state and then maintaining and keeping the first switching element and the second switching element in the OFF state or putting them into the OFF state and then maintaining.
(H) Keeping the first switching element and the second switching element in the ON state or putting them into the ON state and then maintaining.

According to the present aspect, even in a case where the parallel arc discharge occurs in a portion between the bidirectional converter portion and the power conversion device, the parallel arc discharge can be promptly extinguished without providing a breaker.

In a more preferable aspect, in the second parallel arc interruption operation, distribution of power with respect to the bidirectional converter portion is interrupted by a power-storage-side interrupter included in the power storage module.

In a preferable aspect, the bidirectional converter portion has a power-storage-side connection part electrically connected to the power storage module and a conversion-side connection part electrically connected to the power conversion device, the bidirectional converter portion has a step-down circuit in which the power-storage-side connection part, a reactor portion, a second switching element, and the conversion-side connection part are connected in series, and a first rectifying portion is connected in parallel to the reactor portion and the power storage module; and a boost circuit in which the power-storage-side connection part, the reactor portion, a second rectifying portion, and the conversion-side connection part are connected in series, and a first switching element is connected in parallel to the reactor portion and the power storage module, the bidirectional converter portion is capable of executing a step-down operation that steps down an input voltage from the power conversion device by putting the first switching element into an OFF state and switching between an ON state and an OFF state of the second switching element, and outputs power to the power storage module; and a boost operation that boosts the input voltage from the power storage module by putting the second switching element into the OFF state and switching between the ON state and the OFF state of the first switching element, and outputs power to the power conversion device, the power supply system further includes a second series arc detector that detects series arc discharge in a portion between the bidirectional converter portion and the power conversion device, and when the second series arc detector detects series arc discharge, a second series arc interruption operation in which following (I) and/or (J) is performed is executed.
(I) Interrupting to input and to output power to and from the bidirectional converter portion by a power-storage-side interrupter included in the power storage module, and keeping the first switching element and/or the second switching element in the OFF state or putting it into the OFF state and then maintaining.
(J) Keeping the first switching element and the second switching element in the OFF state or putting them into the OFF state and then maintaining.

In a more preferable aspect, the power conversion device has a system-side connection terminal connectable to a system power supply portion, and an inverter portion having an inverter-side interrupter that is capable of interrupting supply of power to the system-side connection terminal side, and the second series arc interruption operation performs at least the (I) or the (J) in a case where a voltage of the inverter portion exceeds a voltage of the power storage module, and performs at least a combination of the (I) or the (J) and following (K) in a case where the voltage of the inverter portion is equal to or less than the voltage of the power storage module.

(K) Interrupting supply of power to the system-side connection terminal side by the inverter-side interrupter.

In a preferable aspect, the power supply system further includes a power generation module; and a power-generation-side series arc detector, in which the power conversion device has a boost converter portion, the boost converter portion has a power-generation-side boost circuit in which a power-generation-side reactor portion and a power-generation-side switching element are connected in series, and is capable of executing a power-generation-side boost operation of boosting an input voltage from the power generation module by switching between an ON state and an OFF state of the power-generation-side switching element and outputting power to the bidirectional converter portion, the boost converter portion has a power-generation-side rectifying portion that allows a flow of a current from the power-generation-side boost circuit side to the bidirectional converter portion side and interrupts a flow of a current from the bidirectional converter portion side to the power-generation-side boost circuit side, the power-generation-side series arc detector detects series arc discharge in a portion closer to the power generation module than to the power conversion device, and when the power-generation-side series arc detector detects series arc discharge, a power-generation-side series arc interruption operation in which the power-generation-side switching element is kept in the OFF state or is put into the OFF state and then maintained is executed.

In a preferable aspect, the power supply system further includes a power generation module; and a power-generation-side parallel arc detector, in which the power conversion device has a boost converter portion, the boost converter portion has a power-generation-side boost circuit in which a power-generation-side reactor portion and a power-generation-side switching element are connected in series, and is capable of executing a power-generation-side boost operation of boosting an input voltage from the power generation module by switching between an ON state and an OFF state of the power-generation-side switching element and outputting power to the bidirectional converter portion, the power-generation-side parallel arc detector detects parallel arc discharge in a portion closer to the power generation module than to the power conversion device, and when the power-generation-side parallel arc detector detects parallel arc discharge, a power-generation-side parallel arc interruption operation in which the power-generation-side switching element is kept in the ON state or is put into the ON state and then maintained is executed.

In a preferable aspect, the power supply system further includes a series arc interrupter, in which the series arc interrupter is provided between the power conversion device and the bidirectional converter portion, and when the arc discharge detector detects arc discharge, the series arc interrupter interrupts conduction of power between the power conversion device and the bidirectional converter portion.

According to the present aspect, when the arc discharge is detected in a portion between the power conversion device and the bidirectional converter portion, the conduction between the power conversion device and the bidirectional converter portion is interrupted. Therefore, in a case where the series arc discharge occurs in a portion between the power conversion device and the bidirectional converter portion, the arc discharge can be promptly extinguished.

In a preferable aspect, the power supply system further includes a positive-electrode-side wiring portion; a negative-electrode-side wiring portion; and a parallel arc short-circuit portion, in which the bidirectional converter portion is connected to the power conversion device via the positive-electrode-side wiring portion and the negative-electrode-side wiring portion, and the parallel arc short-circuit portion makes, after the series arc interrupter interrupts the conduction of power between the power conversion device and the bidirectional converter portion, and when the arc discharge detector detects arc discharge, the positive-electrode-side wiring portion and the negative-electrode-side wiring portion conductive.

According to the present aspect, even in a case where the parallel arc discharge occurs in a portion between the power conversion device and the bidirectional converter portion, the arc discharge can be promptly extinguished.

In a preferable aspect, the power conversion device has the inverter portion, the bidirectional converter portion is connected to the inverter portion, the arc discharge detector detects arc discharge between the inverter portion and the bidirectional converter portion, the series arc interrupter is provided between the inverter portion and the bidirectional converter portion, and when the arc discharge detector detects the arc discharge, conduction of power between the inverter portion and the bidirectional converter portion is interrupted.

According to the present aspect, when the arc discharge is detected in a portion between the inverter portion of the power conversion device and the bidirectional converter portion, the conduction between the inverter portion and the bidirectional converter portion is interrupted. Therefore, in a case where the series arc discharge occurs in a portion between the power conversion device and the bidirectional converter portion, the arc discharge can be promptly extinguished.

In a preferable aspect, the power supply system further includes a positive-electrode-side wiring portion; a negative-electrode-side wiring portion; and a parallel arc short-circuit portion, in which the bidirectional converter portion is connected to the inverter portion via the positive-electrode-side wiring portion and the negative-electrode-side wiring portion, and the parallel arc short-circuit portion makes, after the series arc interrupter interrupts the conduction of power between the inverter portion and the bidirectional converter portion, and when the arc discharge detector detects arc discharge, the positive-electrode-side wiring portion and the negative-electrode-side wiring portion conductive.

According to the present aspect, even in a case where the parallel arc discharge occurs in a portion between the inverter portion and the bidirectional converter portion, the arc discharge can be promptly extinguished.

In a preferable aspect, the power supply system further includes a power generation module, the power generation module is connected to the power storage module via the power conversion device and the bidirectional converter portion, the power conversion device has a boost converter portion, the bidirectional converter portion is electrically connected to the power generation module via the boost converter portion, the arc discharge detector detects arc discharge between the boost converter portion and the bidirectional converter portion, the series arc interrupter is provided between the boost converter portion and the bidirectional converter portion, and when the arc discharge detector detects the arc discharge, conduction of power between the boost converter portion and the bidirectional converter portion is interrupted.

According to the present aspect, when the arc discharge is detected in a portion between the boost converter portion of the power conversion device and the bidirectional converter portion, the conduction between the boost converter portion and the bidirectional converter portion is interrupted. Therefore, in a case where the series arc discharge occurs in a portion between the power conversion device and the bidirectional converter portion, the arc discharge can be promptly extinguished.

In a preferable aspect, the power supply system further includes a positive-electrode-side wiring portion; a negative-electrode-side wiring portion; and a parallel arc short-circuit portion, in which the bidirectional converter portion is connected to the boost converter portion via the positive-electrode-side wiring portion and the negative-electrode-side wiring portion, and the parallel arc short-circuit portion makes, after the series arc interrupter interrupts the conduction of power between the boost converter portion and the bidirectional converter portion, and when the arc discharge detector detects arc discharge, the positive-electrode-side wiring portion and the negative-electrode-side wiring portion conductive.

According to the present aspect, even in a case where the parallel arc discharge occurs in a portion between the boost converter portion and the bidirectional converter portion, the arc discharge can be promptly extinguished.

In a preferable aspect, the series arc interrupter is provided outside the power conversion device.

According to the present aspect, it is possible to cope with the series arc discharge without modifying the inside of the power conversion device.

In a preferable aspect, the parallel arc short-circuit portion is provided outside the power conversion device.

According to the present aspect, it is possible to cope with the parallel arc discharge without modifying the inside of the power conversion device.

An aspect of the present invention is a power supply system including a power storage module; a power conversion device; and a bidirectional converter portion, in which the power storage module is connected to the power conversion device via the bidirectional converter portion, the power conversion device has an inverter portion, and a system-side connection terminal connectable to a system power supply portion, the inverter portion includes a third switching element, a fourth switching element, a fifth switching element, and a sixth switching element; and is provided with a full-bridge circuit in which the third switching element and the sixth switching element, and the fourth switching element and the fifth switching element are respectively arranged diagonally, the inverter portion includes a system interrupter that interrupts distribution of power between the full-bridge circuit side and the system-side connection terminal side, the bidirectional converter portion has a power-storage-side connection part electrically connected to the power storage module, and a conversion-side connection part electrically connected to the power conversion device, the bidirectional converter portion has a step-down circuit in which the power-storage-side connection part, a reactor portion, a second switching element, and the conversion-side connection part are connected in series, and a first rectifying portion is connected in parallel to the reactor portion and the power storage module; and a boost circuit in which the power-storage-side connection part, the reactor portion, a second rectifying portion, and the conversion-side connection part are connected in series, and a first switching element is connected in parallel to the reactor portion and the power storage module, the bidirectional converter portion is capable of executing a step-down operation that steps down an input voltage from the power conversion device by putting the first switching element into an OFF state and switching between an ON state and an OFF state of the second switching element, and outputs power to the power storage module; and a boost operation that boosts the input voltage from the power storage module by putting the second switching element into the OFF state and switching between the ON state and the OFF state of the first switching element, and outputs power to the power conversion device, the power supply system further includes a parallel arc detector that detects parallel arc discharge in a portion closer to the power storage module than to the bidirectional converter portion, and when the parallel arc detector detects parallel arc discharge, the second switching element is kept in an OFF state or is put into the OFF state and then maintained, and a parallel arc interruption operation in which at least one of following (D) to (F) is performed is executed.
(D) Interrupting to input and to output power to and from the bidirectional converter portion by a power-storage-side interrupter included in the power storage module.
(E) Keeping the first switching element in the ON state or putting it into the ON state and then maintaining.
(F) Interrupting conduction of power between the full-bridge circuit side and the system-side connection terminal side by the system interrupter, and keeping the third switching element and the fifth switching element and/or the fourth switching element and the sixth switching element in the ON state or putting them into the ON state and then maintaining.

According to the present aspect, even in a case where the parallel arc discharge occurs in a portion closer to the power storage module than to the bidirectional converter portion, the parallel arc discharge can be promptly extinguished without providing a breaker.

Incidentally, depending on a detection method of the arc discharge, it may be possible to determine whether the type of arc discharge is a series arc discharge or a parallel arc discharge.

Therefore, an aspect of the present invention is a power supply system including a power storage module; a power conversion device; a bidirectional converter portion; a positive-electrode-side wiring portion; a negative-electrode-side wiring portion; a parallel arc discharge detector; and a parallel arc short-circuit portion, in which the power storage module is connected to the power conversion device via the bidirectional converter portion, the power conversion device has an inverter portion, the bidirectional converter portion is connected to the inverter portion via the positive-electrode-side wiring portion and the negative-electrode-side wiring portion, the parallel arc discharge detector detects parallel arc discharge between the inverter portion and the bidirectional converter portion, and the parallel arc short-circuit portion makes the positive-electrode-side wiring portion and the negative-electrode-side wiring portion conductive when the parallel arc discharge detector detects the parallel arc discharge.

According to the present aspect, when the parallel arc discharge is detected in a portion between the inverter portion of the power conversion device and the bidirectional converter portion, the positive-electrode-side wiring portion and the negative-electrode-side wiring portion that connect the inverter portion and the bidirectional converter portion are made conductive, and the parallel arc discharge can be promptly extinguished.

An aspect of the present invention is a power supply system including a power generation module; a power storage module; a power conversion device; a bidirectional converter portion; a positive-electrode-side wiring portion; a negative-electrode-side wiring portion; a parallel arc discharge detector; and a parallel arc short-circuit portion, in which the power generation module is connected to the power storage module via the power conversion device and the bidirectional converter portion, the power conversion device has a boost converter portion, the bidirectional converter portion is connected to the boost converter portion via the positive-electrode-side wiring portion and the negative-electrode-side wiring portion, the parallel arc discharge detector detects parallel arc discharge between the boost converter portion and the bidirectional converter portion, and the parallel arc short-circuit portion makes the positive-electrode-side wiring portion and the negative-electrode-side wiring portion conductive when the parallel arc discharge detector detects the parallel arc discharge.

According to the present aspect, when the parallel arc discharge is detected in a portion between the boost converter portion of the power conversion device and the bidirectional converter portion, because the positive-electrode-side wiring portion and the negative-electrode-side wiring portion that connect the boost converter portion and the bidirectional converter portion are made conductive, the parallel arc discharge can be promptly extinguished.

### EFFECT OF INVENTION

With the power supply system according to the present invention, in a portion closer to the power storage module than to the power conversion device, it is possible to promptly extinguish the arc discharge in a case where the series arc discharge or the parallel arc discharge occurs.

### BRIEF DESCRIPTION OF DRAWINGS

Fig. 1 is a block diagram of a power supply system according to a first embodiment of the present invention.
Fig. 2 is an explanatory diagram of a generated power supply mode of the power supply system of Fig. 1, in which a flow of power is indicated by a thick line.
Fig. 3 is an explanatory diagram of a generated power charging mode of the power supply system of Fig. 1, in which a flow of power is indicated by a thick line.
Fig. 4 is an explanatory diagram of a stored power supply mode of the power supply system of Fig. 1, in which a flow of power is indicated by a thick line.
Fig. 5 is an explanatory diagram of a system power charging mode of the power supply system of Fig. 1, in which a flow of power is indicated by a thick line.
Fig. 6 is an electric circuit diagram of the power supply system of Fig. 1.
Fig. 7 is a flowchart of a driving operation of the power supply system of Fig. 1.
Fig. 8 is a flowchart of a first series arc interruption operation of the power supply system of Fig. 7.
Fig. 9 is a flowchart of a first parallel arc interruption operation of the power supply system of Fig. 7.
Fig. 10 is a flowchart of a second series arc interruption operation of the power supply system of Fig. 7.
Fig. 11 is a flowchart of a second parallel arc interruption operation of the power supply system of Fig. 7.
Fig. 12 is a flowchart following the second parallel arc interruption operation of Fig. 11.
Fig. 13 is a flowchart of a third series arc interruption operation of the power supply system of Fig. 7.
Fig. 14 is a flowchart of a third parallel arc interruption operation of the power supply system of Fig. 7.
Fig. 15 is a block diagram of a power supply system according to a second embodiment of the present invention.
Fig. 16 is an explanatory diagram of a generated power supply mode of the power supply system of Fig. 15, in which a flow of power is indicated by a thick line.
Fig. 17 is an explanatory diagram of a generated power charging mode of the power supply system of Fig. 15, in which a flow of power is indicated by a thick line.
Fig. 18 is an explanatory diagram of a stored power supply mode of the power supply system of Fig. 15, in which a flow of power is indicated by a thick line.
Fig. 19 is an explanatory diagram of a system power charging mode of the power supply system of Fig. 15, in which a flow of power is indicated by a thick line.
Fig. 20 is an electric circuit diagram of the power supply system of Fig. 15.
Fig. 21 is a flowchart of an arc interruption operation of the power supply system of Fig. 15.
Fig. 22 is a block diagram of a power supply system according to another embodiment of the present invention.

### BEST MODE FOR CARRYING OUT THE INVENTION

Hereinafter, embodiments of the present invention will be described in detail.

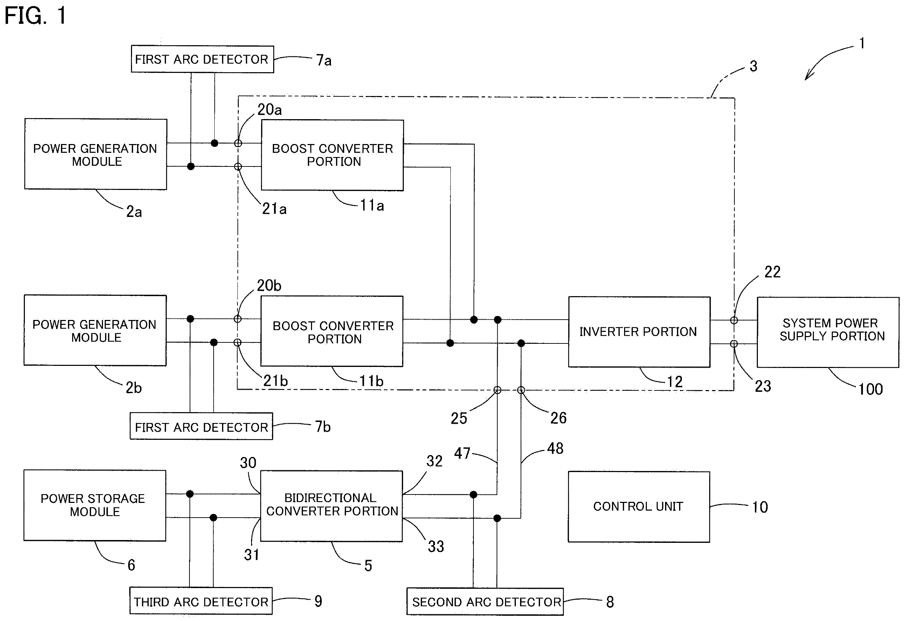

As illustrated in Fig. 1, a power supply system 1 according to a first embodiment of the present invention includes power generation modules 2a and 2b, a power conversion device 3, a bidirectional converter portion 5, a power storage module 6, first arc detectors 7a and 7b (power-generation-side series arc detector, power-generation-side parallel arc detector), a second arc detector 8 (arc discharge detector, second parallel arc detector, second series arc detector), a third arc detector 9 (arc discharge detector, parallel arc detector, series arc detector), a positive-electrode-side wiring portion 47, a negative-electrode-side wiring portion 48, and a control unit 10, and can connect a system power supply portion 100 to the power conversion device 3.

And the power supply system 1 supplies the power generated by the power generation modules 2a and 2b and the power stored in the power storage module 6 to the system power supply portion 100 connected to the power conversion device 3.

The power supply system 1 can execute a generated power supply mode, a generated power charging mode, a stored power supply mode, and a system power charging mode.

### (Generated Power Supply Mode)

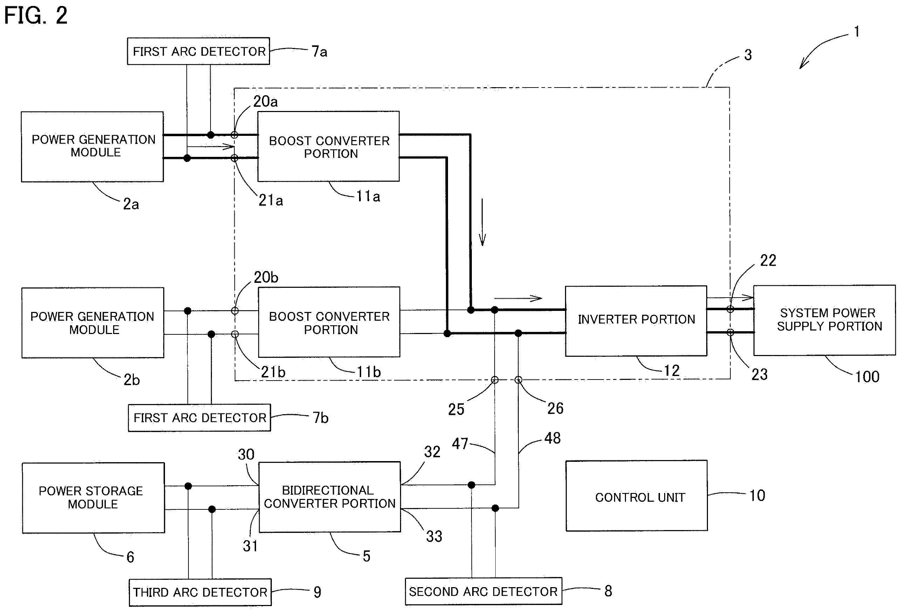

As illustrated in Fig. 2, the generated power supply mode is a mode in which the DC power generated by the power generation module 2a (2b) is supplied to the power conversion device 3, the input voltage from the power generation module 2a (2b) is boosted by a boost converter portion 11a (11b) of the power conversion device 3, and the boosted power is converted from the DC power to the AC power by an inverter portion 12 and supplied to the system power supply portion 100.

### (Generated Power Charging Mode)

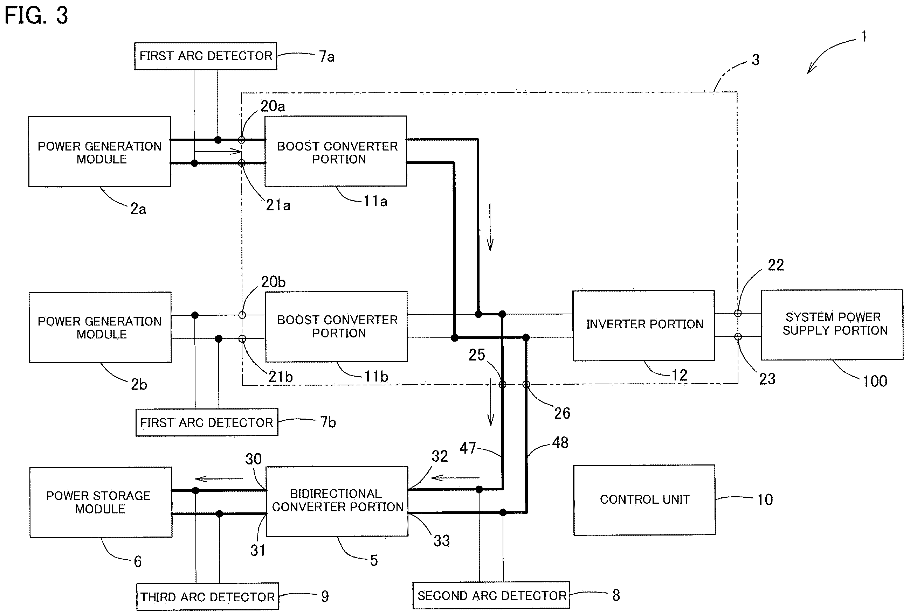

As illustrated in Fig. 3, the generated power charging mode is a mode in which the DC power generated by the power generation module 2a (2b) is supplied to power conversion device 3, the input voltage from power generation module 2a (2b) is boosted by the boost converter portion 11a (11b) of the power conversion device 3, the boosted power is supplied to the bidirectional converter portion 5, the input voltage from the boost converter portion 11a (11b) is stepped down by the bidirectional converter portion 5, and the stepped-down power is charged into the power storage module 6.

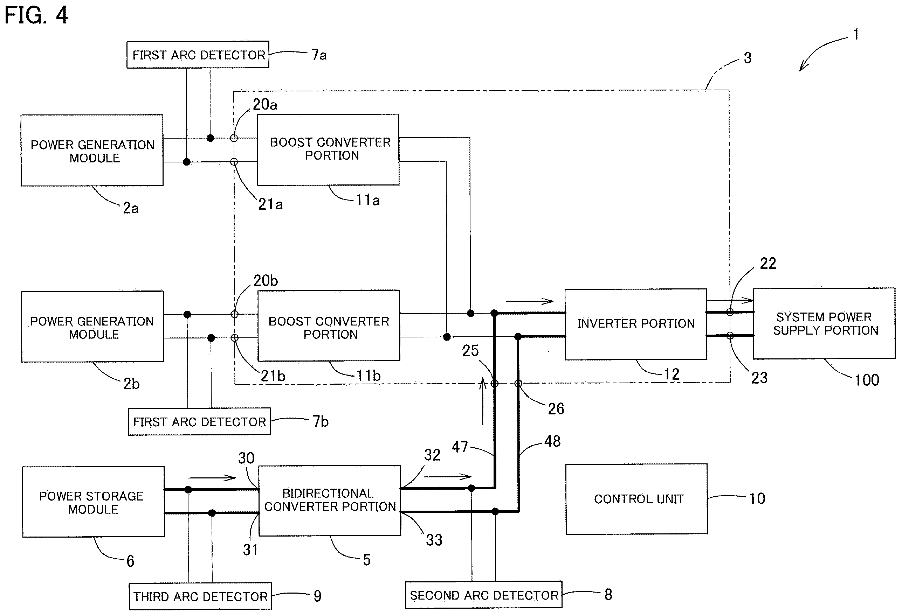

As illustrated in Fig. 4, the stored power supply mode is a mode in which the power stored in the power storage module 6 is supplied to the bidirectional converter portion 5, the input voltage from the power storage module 6 is boosted by the bidirectional converter portion 5, the boosted power is supplied to the power conversion device 3, the DC power is converted into the AC power by the power conversion device 3, and the AC power is supplied to the system power supply portion 100.

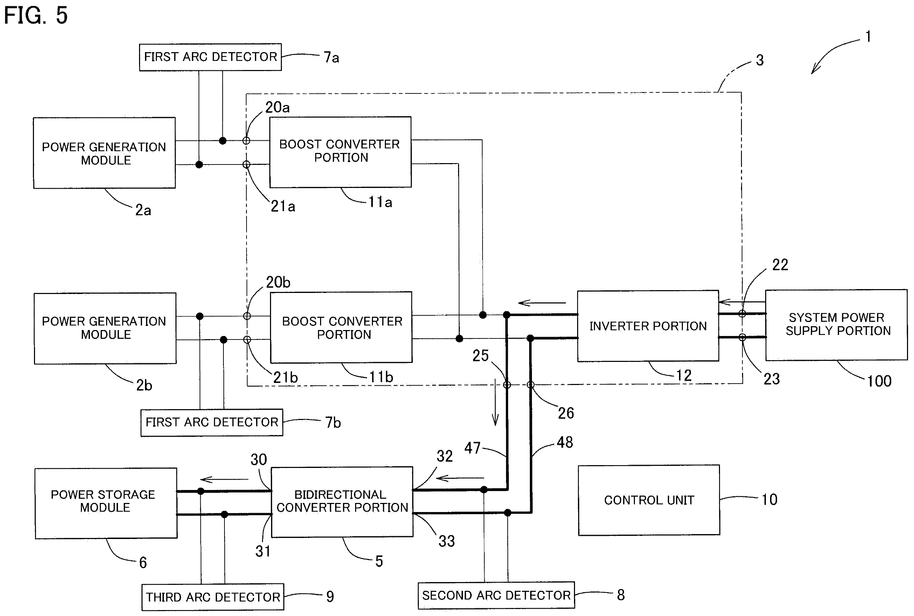

As illustrated in Fig. 5, the system power charging mode is a mode in which power is supplied from the system power supply portion 100 to the power conversion device 3, the AC power is converted into the DC power by the inverter portion 12 of the power conversion device 3, the converted DC power is supplied from the inverter portion 12 to the bidirectional converter portion 5, and the input voltage from the inverter portion 12 is stepped down by the bidirectional converter portion 5 to charge the power storage module 6.

### (Power Generation Module 2)

The power generation module 2 (2a, 2b) generates power using renewable energy such as a solar cell module or a fuel cell module.

Both the power generation modules 2a and 2b of the present embodiment use a solar cell module that converts light energy into electric energy.

In the power generation modules 2a and 2b, a plurality of solar cell groups are connected in series or connected in series and in parallel, and each solar cell group has a plurality of solar cells connected in series.

### (Power Conversion Device 3)

As illustrated in Fig. 1, the power conversion device 3 includes the boost converter portion 11 (11a, 11b), an inverter portion 12, positive-electrode-side input terminals 20a and 20b, negative-electrode-side input terminals 21a and 21b, system-side connection terminals 22 and 23, and converter-side connection terminals 25 and 26.

### (Boost converter portion 11)

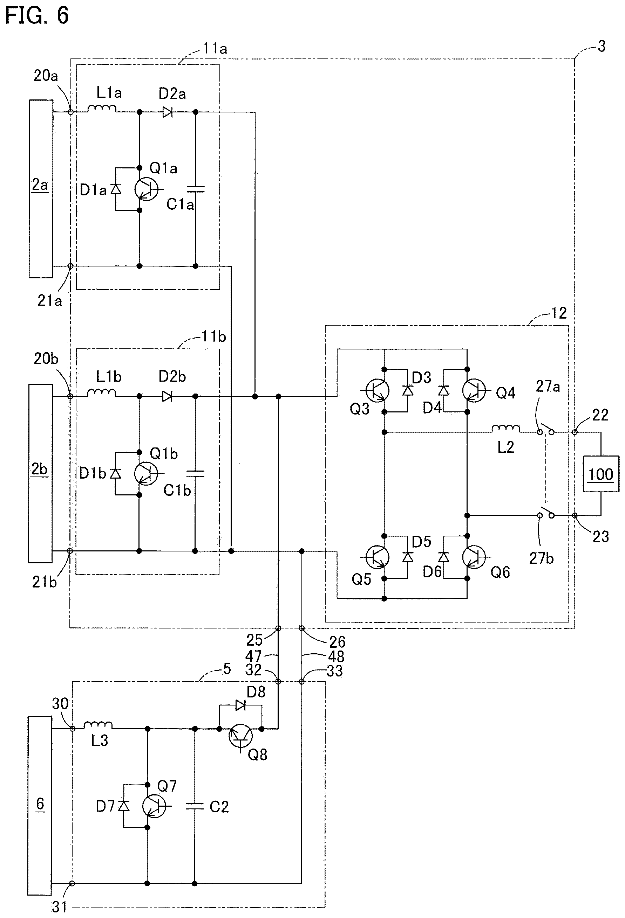

As illustrated in Fig. 6, the boost converter portion 11(11a, 11b) is connected to the power generation modules 2a and 2b via the positive-electrode-side input terminals 20a and 20b and the negative-electrode-side input terminals 21a and 21b, respectively, and is connected to the bidirectional converter portion 5 via the converter-side connection terminals 25 and 26.

The boost converter portion 11a (11b) is a non-isolated DC-DC converter, and includes a reactor portion L1a (L1b) (power-generation-side reactor portion), a switching element Q1a (Q1b) (power-generation-side switching element), diode portions D1a and D2a (D1b, D2b), and a capacitor portion C1a (C1b) as illustrated in Fig. 6.

The boost converter portion 11a (11b) is a so-called chopper type DC-DC converter, and includes a boost circuit (power-generation-side boost circuit) in which the positive-electrode-side input terminal 20a (20b), the reactor portion L1a (L1b), the switching element Q1a (Q1b), and the negative-electrode-side input terminal 21a (21b) are connected in series.

The boost converter portion 11a (11b) can executes a boost operation (power-generation-side boost operation), in the boost operation; the power input from the power generation module 2a (2b) to the positive-electrode-side input terminal 20a (20b) is boosted by switching the switching element Q1a (Q1b) between an ON state and an OFF state in the boost circuit according to a PWM control signal received from the control unit 10, and the boosted power is supplied to the inverter portion 12 and the bidirectional converter portion 5.

That is, in the boost converter portion 11a (11b); the boost circuit forms a closed circuit together with the power generation module 2a (2b), by putting the switching element Q1a (Q1b) into the ON state, and stores energy in the reactor portion L1a (L1b); and the boost circuit forms an open circuit, by putting the switching element Q1a (Q1b) into the OFF state, and releases the energy stored in the reactor portion L1a (L1b).

In addition, the boost converter portion 11a (11b) is capable of boosting the voltage to a desired voltage through controlling the ON state and the OFF state of the switching element Q1a (Q1b) by the duty ratio control according to the PWM control signal from the control unit 10.

In addition, in the boost converter portion 11a (11b), the positive-electrode-side input terminal 20a, the reactor portion L1a (L1b), the diode portion D2a (D2b), the capacitor portion C1a (C1b), and the negative-electrode-side input terminal 21a (21b) are connected in series.

The switching element Q1a (Q1b) and the diode portion D1a (D1b) are connected in parallel respectively to the diode portion D2a (D2b) and the capacitor portion C1a (C1b), and are also connected in parallel respectively to the power generation module 2a (2b) and the reactor portion L1a (L1b).

The switching element Q1a (Q1b) can switch between the ON state and the OFF state by the PWM control signal generated by the control unit 10, and a transistor such as a bipolar transistor, an electrolytic effect transistor, or an insulated gate bipolar transistor (IGBT), a relay switch, or the like can be used.

The diode portions D1a and D2a (D1b, D2b) are rectifying portions that rectify the current in one direction.

The diode portion D1a (D1b) is provided corresponding to the switching element Q1a (Q1b), allows the flow of the current in a direction opposite to the flow of the current in the ON state of the switching element Q1a (Q1b), and can interrupt the flow of the current in the same direction.

That is, the diode portion D1a (D1b) can allow the flow of the current from the negative-electrode-side input terminal 21a (21b) side to the positive-electrode-side input terminal 20a (20b) side, and interrupt the flow of the current from the positive-electrode-side input terminal 20a (20b) side to the negative-electrode-side input terminal 21a (21b) side.

The diode portion D2a (D2b) (power-generation-side rectifying portion) can allow the flow of the current from the boost circuit side to the inverter portion 12 side and the bidirectional converter portion 5 side, and interrupt the flow of the current from the inverter portion 12 side and the bidirectional converter portion 5 side to the boost circuit side.

### (Inverter portion 12)

The inverter portion 12 is a part that alternately converts DC power and AC power, can convert the DC power supplied from the power generation modules 2a and 2b side and the DC power supplied from the power storage module 6 side into the AC power, and can convert the AC power supplied from the system power supply portion 100 side into the DC power.

As illustrated in Fig. 6, the inverter portion 12 includes switching elements Q3 to Q6, diode portions D3 to D6, a reactor portion L2, and system relay portions 27a and 27b (inverter-side interrupter, system interrupter).

The inverter portion 12 can be connected to the system power supply portion 100 via the system-side connection terminals 22 and 23, and is connected to the bidirectional converter portion 5 via the converter-side connection terminals 25 and 26.

In the inverter portion 12, the switching elements Q3 and Q6 (third switching element, sixth switching element, inverter-side interrupter), and the switching elements Q4 and Q5 (fourth switching element, fifth switching element, inverter-side interrupter) are respectively arranged diagonally, and the inverter portion 12 includes a first arm in which the switching element Q3 and the switching element Q5 are connected in series, and a second arm in which the switching element Q4 and the switching element Q6 are connected in series.

The inverter portion 12 includes a full-bridge circuit in which the first arm and the second arm are connected in parallel, and the AC power is input and output from a midpoint of the first arm and a midpoint of the second arm.

The inverter portion 12 can execute a power conversion operation of converting between the DC power and the AC power in accordance with an ON/OFF cycle of each of the switching elements Q3 to Q6 by the PWM control signal from the control unit 10.

In addition, in the inverter portion 12, the system relay portions 27a and 27b are respectively provided between the midpoint of the first arm and the system-side connection terminal 22 and between the midpoint of the second arm and the system-side connection terminal 23.

When the inverter portion 12 is connected to the system power supply portion 100, the switching element Q3, the reactor portion L2, the system relay portion 27a, the system power supply portion 100, the system relay portion 27b, and the switching element Q6 are connected in series, and the switching element Q4, the system relay portion 27b, the system power supply portion 100, the system relay portion 27a, the reactor portion L2, and the switching element Q5 are connected in series.

The inverter portion 12 constitutes an inverter-side interrupter that interrupts the power input from the boost converter portions 11a and 11b and the bidirectional converter portion 5 to the system power supply portion 100 side by the switching elements Q3 to Q6.

That is, by putting the switching elements Q3 and Q4 or the switching elements Q5 and Q6 into the OFF state, the inverter portion 12 can interrupt the distribution of power from the boost converter portions 11a and 11b side and the bidirectional converter portion 5 side to the system-side connection terminals 22 and 23 side.

The switching elements Q3 to Q6 can switch between the ON state and the OFF state by the PWM control signal from the control unit 10, and a transistor such as a bipolar transistor, an electrolytic effect transistor, or an insulated gate bipolar transistor (IGBT), a relay switch, or the like can be used.

The diode portions D3 to D6 are provided corresponding in parallel to the switching elements Q3 to Q6, allow the flow of the current in a direction opposite to the flow of the current in the ON state of the switching elements Q3 to Q6, and can interrupt the flow of the current in the same direction.

The system relay portions 27a and 27b (inverter-side interrupter, system interrupter) are relays that automatically open and close the switches, and are parts that open and close the distribution of power between the full-bridge circuit side and the system-side connection terminals 22 and 23 by turning on and off.

The positive-electrode-side input terminals 20a and 20b are terminals connected to the positive electrode side of the power generation modules 2a and 2b via a wiring member such as a cable.

The negative-electrode-side input terminals 21a and 21b are terminals connected to the negative electrode side of the power generation modules 2a and 2b via a wiring member such as a cable.

The system-side connection terminals 22 and 23 are terminals that can be connected to the system power supply portion 100 via a wiring member such as a cable.

The converter-side connection terminals 25 and 26 are terminals connected to the bidirectional converter portion 5 via a wiring member (wiring portions 47 and 48) such as a cable.

### (Bidirectional converter portion 5)

The bidirectional converter portion 5 is a step-down converter that steps down the power supplied from the power conversion device 3 side and supplies the stepped-down power to the power storage module 6, and is also a boost converter that boosts the power supplied from the power storage module 6 and supplies the boosted power to the power conversion device 3 side.

As illustrated in Fig. 6, the bidirectional converter portion 5 includes a reactor portion L3, switching elements Q7 and Q8, diode portions D7 and D8, a capacitor portion C2, power-storage-side connection terminals 30 and 31 (power-storage-side connection part), and conversion-side connection terminals 32 and 33 (conversion-side connection part).

The bidirectional converter portion 5 includes a step-down circuit in which the power-storage-side connection terminal 30, the reactor portion L3, the switching element Q8, and the conversion-side connection terminal 32 are connected in series, and the diode portion D7 is connected in parallel to the power storage module 6 and the reactor portion L3.

The bidirectional converter portion 5 can execute a step-down operation that steps down, in the step-down circuit, the power input from the power conversion device 3 side to the conversion-side connection terminal 32 by putting the switching element Q7 (first switching element) into the OFF state and switching the switching element Q8 (second switching element) between the ON state and the OFF state, and supplies the power from the power-storage-side connection terminal 30 to the power storage module 6.

That is, the bidirectional converter portion 5 stores energy in the reactor portion L3 by putting the switching element Q7 into the OFF state and putting the switching element Q8 into the ON state, generates electromotive force in the reactor portion L3 by putting the switching element Q8 into the OFF state, and can output the current from the power-storage-side connection terminal 30 to the power storage module 6 through the diode portion D7.

The bidirectional converter portion 5 includes a boost circuit in which the power-storage-side connection terminal 30, the reactor portion L3, the switching element Q8, and the conversion-side connection terminal 32 are connected in series, and the switching element Q7 is connected in parallel to the power storage module 6 and the reactor portion L3.

In addition, in the booster circuit, the power-storage-side connection terminal 30, the reactor portion L3, the diode portion D8, and the conversion-side connection terminal 32 are connected in series, and the diode portion D8 is connected in parallel to the switching element Q8.

The bidirectional converter portion 5 can execute a boost operation, in the boost operation; the power input from the power storage module 6 to the power-storage-side connection terminal 30 is boosted by putting the switching element Q8 into the OFF state and switching the switching element Q7 between the ON state and the OFF state in the boost circuit, and the boosted power is supplied from the conversion-side connection terminal 32 to the power conversion device 3.

That is, in the bidirectional converter portion 5, by putting the switching element Q8 into the OFF state and putting the switching element Q7 into the ON state, the boost circuit forms a closed circuit together with the power storage module 6 and stores energy in the reactor portion L3, and by putting the switching element Q7 into the OFF state, the boost circuit forms an open circuit and releases the energy stored in the reactor portion L3.

The bidirectional converter portion 5 is capable of boosting and stepping down the voltage to a desired voltage by the duty ratio control according to the PWM control signal from the control unit 10.

In the bidirectional converter portion 5, the conversion-side connection terminal 32, the switching element Q8, the switching element Q7, and the conversion-side connection terminal 33 are connected in series.

The switching element Q7, the diode portion D7, and the capacitor portion C2 are connected in parallel to the power storage module 6 and the reactor portion L3, respectively.

The switching elements Q7 and Q8 can switch between the ON state and the OFF state by the PWM control signal generated by the control unit 10, and a transistor such as a bipolar transistor, an electrolytic effect transistor, or an insulated gate bipolar transistor (IGBT), a relay switch, or the like can be used.

The diode portions D7 and D8 are rectifying portions that rectify the current in one direction.

The diode portions D7 and D8 are provided corresponding to the switching elements Q7 and Q8, allows the flow of the current in a direction opposite to the flow of the current in the ON state of the switching elements Q7 and Q8, and can interrupt the flow of the current in the same direction.

That is, the diode portion D7 (first rectifying portion) allows the flow of the current from the conversion-side connection terminal 33 side to the conversion-side connection terminal 32 side, and can interrupt the flow of the current from the conversion-side connection terminal 32 side to the conversion-side connection terminal 33 side.

The diode portion D8 (second rectifying portion) allows the flow of the current from the power-storage-side connection terminal 30 side to the conversion-side connection terminal 32 side, and can interrupt the flow of the current from the conversion-side connection terminal 32 side to the power-storage-side connection terminal 30 side.

The power-storage-side connection terminal 30 is a positive-electrode-side connection terminal connected to the positive electrode side of a secondary battery of the power storage module 6 via a wiring member such as a cable.

The power-storage-side connection terminal 31 is a negative-electrode-side connection terminal connected to the negative electrode side of the secondary battery of the power storage module 6 via a wiring member such as a cable.

The conversion-side connection terminals 32 and 33 are terminals connected to the converter-side connection terminals 25 and 26 of the power conversion device 3 via a wiring member (wiring portions 47 and 48) such as a cable.

### (Power Storage Module 6)

The power storage module 6 is a storage battery including one or a plurality of secondary batteries, and can be charged with power generated by the power generation modules 2a and 2b or power supplied from the system power supply portion 100, and can discharge the charged power to the system power supply portion 100.

### (First Arc detectors 7a and 7b)

The first arc detector 7a (7b) is a series arc detector that detects the series arc discharge when the series arc discharge occurs in a portion closer to the power generation module 2a (2b) than to the input terminals 20a and 21a (20b, 21b) of the power conversion device 3 illustrated in Fig. 1, and is also a parallel arc detector that detects the parallel arc discharge when the parallel arc discharge occurs in a portion closer to the power generation module 2a (2b) than to the input terminals 20a and 21a (20b, 21b) of the power conversion device 3.

That is, not only power generation module 2a (2b) but also a wiring member or the like connecting the power generation module 2a (2b) and the input terminals 20a and 21a (20b, 21b) are detection targets of the series arc discharge and the parallel arc discharge in the first arc detector 7a (7b).

### (Second Arc detector 8)

The second arc detector 8 is a series arc detector that detects series arc discharge when series arc discharge occurs in a portion (wiring portions 47 and 48) between the converter-side connection terminals 25 and 26 of the power conversion device 3 and the conversion-side connection terminals 32 and 33 of the bidirectional converter portion 5 illustrated in Figs. 1 and 6, and is also a parallel arc detector that detects parallel arc discharge when parallel arc discharge occurs in a portion (wiring portions 47 and 48) between the converter-side connection terminals 25 and 26 of the power conversion device 3 and the conversion-side connection terminals 32 and 33 of the bidirectional converter portion 5.

### (Third Arc detector 9)

The third arc detector 9 is a series arc detector that detects series arc discharge when series arc discharge occurs in a portion closer to the power storage module 6 than to the power-storage-side connection terminals 30 and 31 of the bidirectional converter portion 5 illustrated in Figs. 1 and 6, and
is also a parallel arc detector that detects parallel arc discharge when parallel arc discharge occurs in a portion closer to the power storage module 6 than to the power-storage-side connection terminals 30 and 31 of the bidirectional converter portion 5.

That is, not only the power storage module 6 but also a wiring member or the like connecting the power storage module 6 and the power-storage-side connection terminals 30 and 31 are detection targets of the series arc discharge and the parallel arc discharge in the third arc detector 9.

### (Positive-Electrode-Side Wiring Portion 47)

The positive-electrode-side wiring portion 47 is a connection wiring line that connects the converter-side connection terminal 25 electrically connected to the positive electrode side of power generation module 2 and the conversion-side connection terminal 32 electrically connected to the positive electrode side of the power storage module 6.

### (Negative-Electrode-Side Wiring Portion 48)

The negative-electrode-side wiring portion 48 is a connection wiring line that connects the converter-side connection terminal 26 electrically connected to the negative electrode side of the power generation module 2 and the conversion-side connection terminal 33 electrically connected to the negative electrode side of the power storage module 6.

### (Control Unit 10)

The control unit 10 includes, as a hardware configuration, a central processing unit including a control device that controls each device and an arithmetic device that performs an arithmetic operation on data, and a computer including a storage device that stores data, an input device that inputs data from the outside, and an output device that outputs data to the outside.

The control unit 10 is a part including a PWM circuit and capable of generating the PWM control signal, and can change the ON state and the OFF state of each of the switching elements Q1a, Q1b, and Q3 to Q8 by transmitting the PWM control signal to each of the switching elements Q1a, Q1b, and Q3 to Q8.

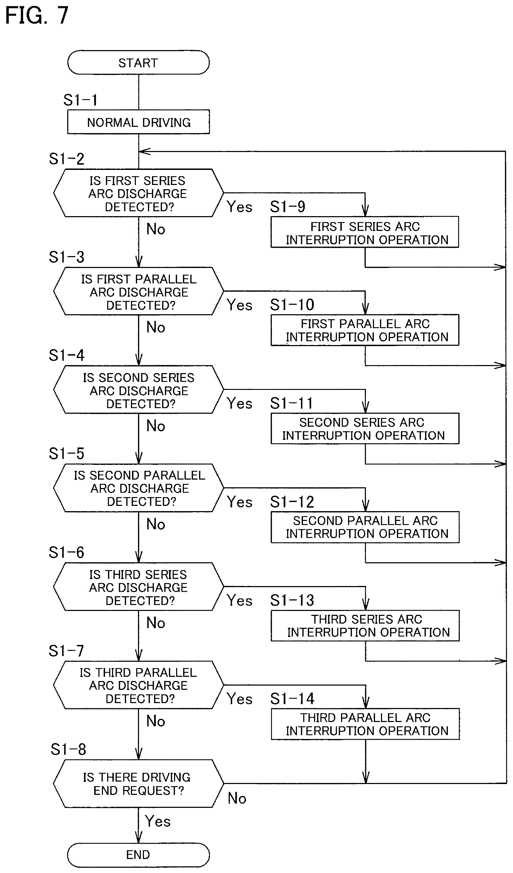

Next, a driving operation of the power supply system 1 will be described with reference to a flowchart of Fig. 7.

The power supply system 1 operates to extinguish series arc discharge or parallel arc discharge when the arc detectors 7a, 7b, 8, and 9 detect the series arc discharge or the parallel arc discharge during the normal driving.

First, normal driving is started in various modes (step S1-1), and it is determined whether or not the first arc detector 7a (7b) detects series arc discharge (hereinafter, referred to as first series arc discharge) (step S1-2).

In a case where the first arc detector 7a (7b) does not detect the first series arc discharge (No in step S1-2), it is determined whether or not the first arc detector 7a (7b) detects parallel arc discharge (hereinafter, referred to as first parallel arc discharge) (step S1-3).

In a case where the first arc detector 7a (7b) does not detect the first parallel arc discharge (No in step S1-3), it is determined whether or not the second arc detector 8 detects series arc discharge (hereinafter, referred to as second series arc discharge) (step S1-4).

In a case where the second arc detector 8 does not detect the second series arc discharge (No in step S1-4), it is determined whether or not the second arc detector 8 detects parallel arc discharge (hereinafter, referred to as second parallel arc discharge) (step S1-5).

In a case where the second arc detector 8 does not detect the second parallel arc discharge (No in step S1-5), it is determined whether or not the third arc detector 9 detects series arc discharge (hereinafter, referred to as third series arc discharge) (step S1-6).

In a case where the third arc detector 9 does not detect the third series arc discharge (No in step S1-6), it is determined whether or not the third arc detector 9 detects parallel arc discharge (hereinafter, referred to as third parallel arc discharge) (step S1-7).

In a case where the third arc detector 9 does not detect the third parallel arc discharge (No in step S 1-7), it is determined whether or not there is a driving end request (step S1-8), and in a case where there is a driving end request (Yes in step S1-8), the driving is ended.

In step S1-2, in a case where the first arc detector 7a (7b) detects the first series arc discharge (Yes in step S1-2), a first series arc interruption operation is executed (step S1-9), and the processing proceeds to step S1-2.

In step S1-3, in a case where the first arc detector 7a (7b) detects the first parallel arc discharge (Yes in step S1-3), a first parallel arc interruption operation is executed (step S1-10), and the processing proceeds to step S1-2.

In step S1-4, in a case where the second arc detector 8 detects the second series arc discharge (Yes in step S1-4), a second series arc interruption operation is executed (step S1-11), and the processing proceeds to step S1-2.

In step S1-5, in a case where the second arc detector 8 detects the second parallel arc discharge (Yes in step S1-5), a second parallel arc interruption operation is executed (step S1-12), and the processing proceeds to step S1-2.

In step S1-6, in a case where the third arc detector 9 detects the third series arc discharge (Yes in step S1-6), a third series arc interruption operation is executed (step S1-13), and the processing proceeds to step S1-2.

In step S1-7, in a case where the third arc detector 9 detects the third parallel arc discharge (Yes in step S1-7), a third parallel arc interruption operation is executed (step S1-14), and the processing proceeds to step S1-2.

In step S1-8, in a case where there is no driving end request (No in step S1-8), the processing proceeds to step S1-2.

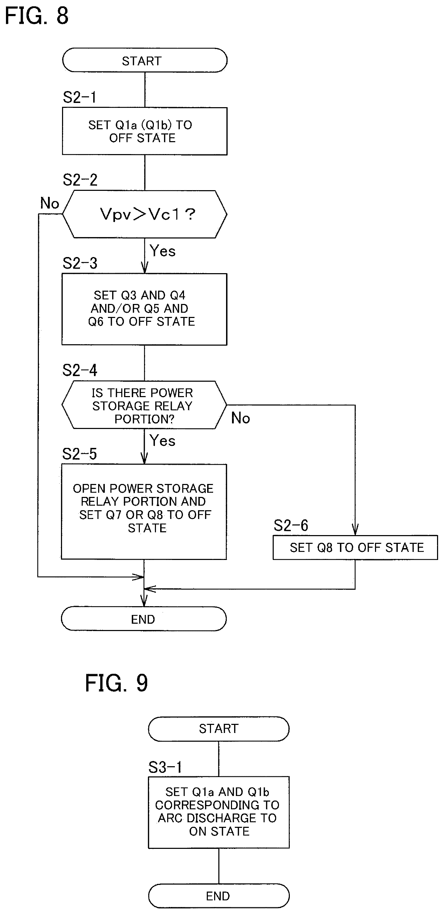

Next, the first series arc interruption operation will be described with reference to the flowchart of Fig. 8.

In the first series arc interruption operation, first, the switching element Q1a (Q1b) is set to the OFF state, and is kept in the OFF state or is put into the OFF state and then maintained (step S2-1), and a voltage Vpv of the power generation module 2a (2b) is compared with a voltage Vc1 of the inverter portion 12 to determine whether or not the voltage Vpv of the power generation module 2a (2b) exceeds the voltage Vc1 of the inverter portion 12 (step S2-2).

At this time, the voltage Vpv of the power generation module 2a (2b) is an output voltage of the power generation module 2a (2b), that is, a voltage between the positive-electrode-side input terminal 20a (20b) and the negative-electrode-side input terminal 21a (21b).

The voltage Vc1 of the inverter portion 12 is an input voltage to the full-bridge circuit or an output voltage from the full-bridge circuit. That is, the voltage Vc1 of the inverter portion 12 is an input/output voltage on the converter-side connection terminals 25 and 26 side.

In step S2-2, in a case where the voltage Vpv of the power generation module 2a (2b) exceeds the voltage Vc1 of the inverter portion 12 (Yes in step S2-2), the current flows from the power generation module 2a (2b) side to the inverter portion 12 side, and therefore the switching elements Q3 and Q4 and/or the switching elements Q5 and Q6 are set to the OFF state, and are kept in the OFF state or are put into the OFF state and then maintained (step S2-3).

Here, the power storage module 6 may or may not include a power storage relay portion (power-storage-side interrupter) that interrupts the distribution of power between the built-in secondary battery and the bidirectional converter portion 5.

In a case where the power storage module 6 includes the power storage relay portion (Yes in step S2-4), the power storage relay portion is opened, and the switching element Q7 or the switching element Q8 is set to the OFF state, and is kept in the OFF state or is put into the OFF state and then maintained (step S2-5).

On the other hand, in a case where the power storage module 6 does not include the power storage relay portion (No in step S2-4), the switching element Q8 is set to the OFF state, and is kept in the OFF state or is put into the OFF state and then maintained (step S2-6).

In step S2-2, in a case where the voltage Vpv of the power generation module 2a (2b) is equal to or less than the voltage Vc1 of the inverter portion 12 (No in step S2-2), the current does not flow from the power generation module 2a (2b) side to the inverter portion 12 side, and thus the processing is ended as it is.

At this time, the response to the series arc discharge is completed in the boost converter portion 11a corresponding to the first arc detector 7a that has detected the series arc discharge, and the remaining members can be operated, so that the normal driving can be executed in various modes between the remaining members.

Next, the first parallel arc interruption operation will be described with reference to the flowchart of Fig. 9.

In the first parallel arc interruption operation, as illustrated in Fig. 9, the switching element Q1a (Q1b) of the boost converter portion 11a (11b) corresponding to the first arc detector 7a (7b) that has detected the first parallel arc discharge is set to the ON state, and is kept in the ON state or is put into the ON state and then maintained, and the positive-electrode-side input terminal 20a (20b) side and the negative-electrode-side input terminal 21a (21b) side are short-circuited (step S3-1).

At this time, the response to the parallel arc discharge is completed in the boost converter portion 11a (11b) corresponding to the first arc detector 7a (7b) that has detected the parallel arc discharge, and the remaining members can be operated, so that the normal driving can be executed in various modes between the remaining members.

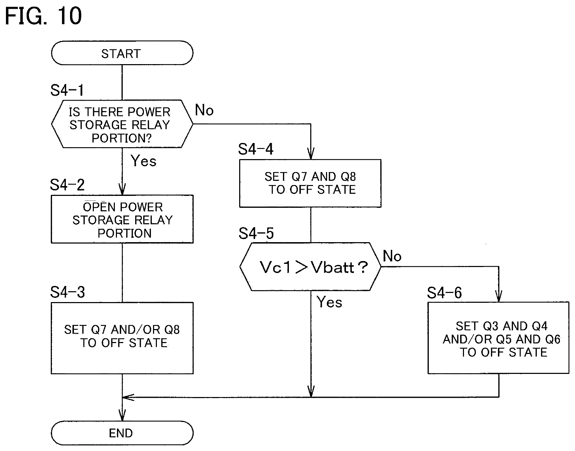

Next, the second series arc interruption operation will be described with reference to the flowchart of Fig. 10.

In the second series arc interruption operation, in a case where the power storage module 6 includes the power storage relay portion (Yes in step S4-1), the power storage relay portion is opened (step S4-2), and the switching element Q7 and/or the switching element Q8 is set to the OFF state, and is kept in the OFF state or is put into the OFF state and then maintained (step S4-3).

At this time, since the response to the series arc discharge is completed in the power storage module 6 and the bidirectional converter portion 5, it is possible to execute the generated power supply mode in which the power storage module 6 and the bidirectional converter portion 5 do not contribute.

On the other hand, in a case where the power storage module 6 does not include the power storage relay portion (No in step S4-1), the switching elements Q7 and Q8 are set to the OFF state, and are kept in the OFF state or are put into the OFF state and then maintained (step S4-4), and it is determined whether or not the voltage Vc1 of the inverter portion 12 exceeds a voltage Vbatt of the power storage module 6 (step S4-5).

At this time, the voltage Vbatt of the power storage module 6 is an input/output voltage of the power storage module 6, that is, a voltage between the power-storage-side connection terminal 30 and the power-storage-side connection terminal 31.

In step S4-5, in a case where the voltage Vc1 of the inverter portion 12 exceeds the voltage Vbatt of the power storage module 6 (Yes in step S4-5), the current does not flow from the power storage module 6 side to the inverter portion 12 side, and thus the processing is ended as it is.

At this time, since the response to the series arc discharge is completed in the power storage module 6 and the bidirectional converter portion 5, it is possible to execute the generated power supply mode in which the power storage module 6 and the bidirectional converter portion 5 do not contribute.

On the other hand, in a case where the voltage Vc1 of the inverter portion 12 is equal to or less than the voltage Vbatt of the power storage module 6 (No in step S4-5), the current flows from the power storage module 6 side to the inverter portion 12 side, and therefore the switching elements Q3 and Q4 and/or the switching elements Q5 and Q6 are set to the OFF state, and are kept in the OFF state or are put into the OFF state and then maintained (step S4-6).

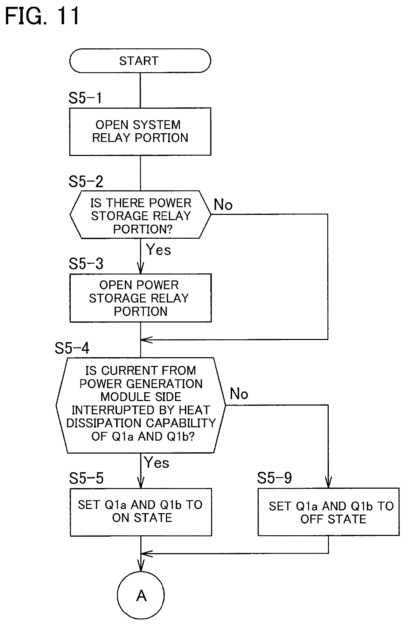

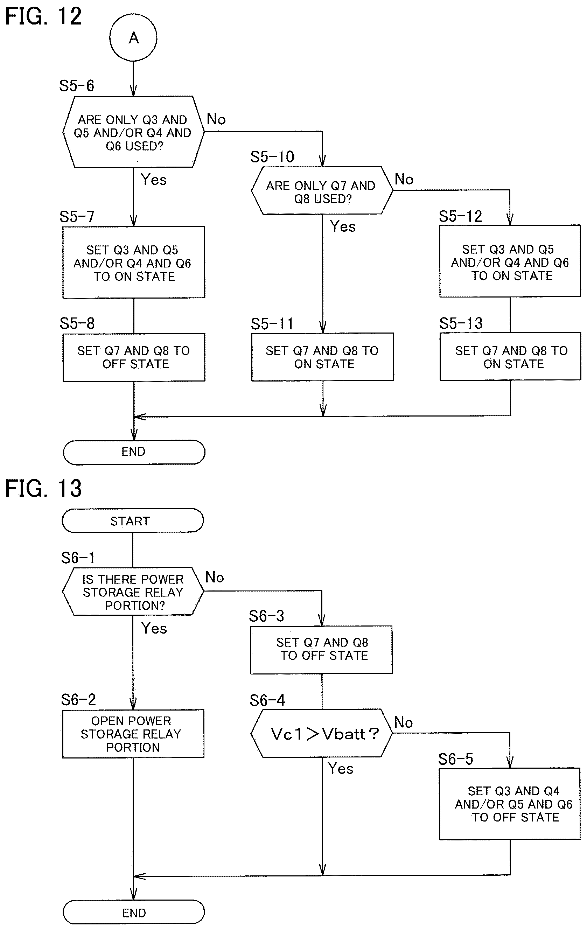

Next, the second parallel arc interruption operation will be described with reference to the flowcharts of Figs. 11 and 12.

In the second parallel arc interruption operation, the system relay portions 27a and 27b are opened to isolate the system power supply portion 100 from the power conversion device 3 (step S5-1), and in a case where the power storage module 6 includes the power storage relay portion (Yes in step S5-2), the power storage relay portion is opened (step S5-3).

Then, in a case where the current from the power generation modules 2a and 2b side is interrupted by the heat dissipation capability of the switching elements Q1a and Q1b (Yes in step S5-4), the switching elements Q1a and Q1b are set to the ON state, and are kept in the ON state or are put into the ON state and then maintained (step S5-5), and the processing proceeds to step S5-6. In a case where the current from the power generation modules 2a and 2b side is not interrupted by the heat dissipation capability of the switching elements Q1a and Q1b (No in step S5-4), the switching elements Q1a and Q1b are set to the OFF state, and are kept in the OFF state or are put into the OFF state and then maintained (step S5-9), and the processing proceeds to step S5-6.

On the other hand, in a case where the power storage module 6 does not include the power storage relay portion (No in step S5-2), the processing directly proceeds to step S5-4.

In step S5-6, in a case where only the switching elements Q3 and Q5 and/or the switching elements Q4 and Q6 are used (Yes in step S5-6), the switching elements Q3 and Q5 and/or the switching elements Q4 and Q6 are set to the ON state, and are kept in the ON state or are put into the ON state and then maintained (step S5-7), and the switching elements Q7 and Q8 are set to the OFF state, and are kept in the OFF state or are put into the OFF state and then maintained (step S5-8).

On the other hand, in a case where only the switching elements Q3 and Q5 and/or the switching elements Q4 and Q6 are not used (No in step S5-6) and only the switching elements Q7 and Q8 are used (Yes in step S5-10), the switching elements Q7 and Q8 are set to the ON state, and are kept in the ON state or are put into the ON state and then maintained.

In addition, in a case where only the switching elements Q3 and Q5 and/or the switching elements Q4 and Q6 are not used (No in step S5-6) and only the switching elements Q7 and Q8 are not used (No in step S5-10), the switching elements Q3 and Q5 and/or the switching elements Q4 and Q6 are set to the ON state, and are kept in the ON state or are put into the ON state and then maintained (step S5-12), and the switching elements Q7 and Q8 are set to the ON state, and are kept in the ON state or are put into the ON state and then maintained (step S5-13).

Next, the third series arc interruption operation will be described with reference to the flowchart of Fig. 13.

In the third series arc interruption operation, in a case where the power storage module 6 includes the power storage relay portion (Yes in step S6-1), the power storage relay portion is opened (step S6-2).

At this time, since the response to the series arc discharge is completed in the power storage module 6, it is possible to execute the generated power supply mode in which the power storage module 6 does not contribute.

In addition, in a case where the power storage module 6 does not include the power storage relay portion (No in step S6-1), the switching elements Q7 and Q8 are set to the OFF state, and are kept in the OFF state or are put into the OFF state and then maintained (step S6-3), and in a case whether the voltage Vc1 of the inverter portion 12 exceeds the voltage Vbatt of the power storage module 6 (Yes in step S6-4), the current from the power storage module 6 side to the inverter portion 12 side does not flow, and the processing is ended as it is.

At this time, since the response to the series arc discharge is completed in the power storage module 6 and the bidirectional converter portion 5, it is possible to execute the generated power supply mode in which the power storage module 6 and the bidirectional converter portion 5 do not contribute.

On the other hand, in step S6-3, in a case where the voltage Vc1 of the inverter portion 12 is equal to or less than the voltage Vbatt of the power storage module 6 (No in step S6-5), the current flows from the power storage module 6 side to the inverter portion 12 side, and therefore the switching elements Q3 and Q4 and/or the switching elements Q5 and Q6 are set to the OFF state, and are kept in the OFF state or are put into the OFF state and then maintained (step S6-6).

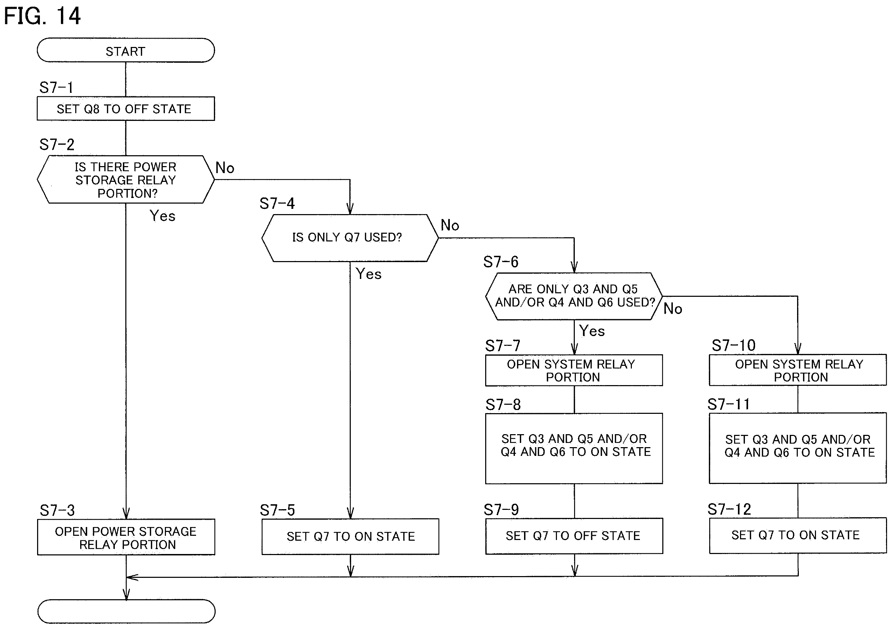

Next, the third parallel arc interruption operation will be described with reference to the flowchart of Fig. 14.

In the third parallel arc interruption operation, the switching element Q8 is set to the OFF state, and is kept in the OFF state or is put into the OFF state and then maintained (step S7-1), and in a case where the power storage module 6 includes the power storage relay portion (Yes in step S7-2), the power storage relay portion is opened (step S7-3).

On the other hand, in a case where the power storage module 6 does not include the power storage relay portion (No in step S7-2), and in a case where only the switching element Q7 is used (Yes in step S7-4), the switching element Q7 is set to the ON state, and is kept in the ON state or is put into the ON state and then maintained (step S7-3).

In addition, in a case where the power storage module 6 does not include the power storage relay portion (No in step S7-2), and in a case where only the switching element Q7 is not used (No in step S7-4) and only the switching elements Q3 and Q5 and/or the switching elements Q4 and Q6 are used (Yes in step S7-6), the system relay portions 27a and 27b are opened (step S7-7), while avoiding the short circuit of the system power supply portion 100, the switching elements Q3 and Q5 and/or the switching elements Q4 and Q6 are set to the ON state, and are kept in the ON state or are put into the ON state and then maintained (step S7-8), and the switching element Q7 is set to the OFF state, and is kept in the OFF state or is put into the OFF state and then maintained (step S7-9).

On the other hand, in a case where the power storage module 6 does not include the power storage relay portion (No in step S7-2), and in a case where only the switching element Q7 is not used (No in step S7-4) and only the switching elements Q3 and Q5 and/or the switching elements Q4 and Q6 are not used, that is, in a case where the switching element Q7 and the switching elements Q3 and Q5 and/or the switching elements Q4 and Q6 are used (No in step S7-6), the system relay portions 27a and 27b are opened (step S7-10), while avoiding the short circuit of the system power supply portion 100, the switching elements Q3 and Q5 and/or the switching elements Q4 and Q6 are set to the ON state, and are kept in the ON state or are put into the ON state and then maintained (step S7-11), and the switching element Q7 is set to the ON state, and is kept in the ON state or is put into the ON state and then maintained (step S7-12).

With the power supply system 1 of the present embodiment, even in a case where the parallel arc discharge occurs in a portion closer to the power storage module 6 than to the bidirectional converter portion 5, the switching element Q8 is kept in the OFF state or is put into the OFF state and then maintained, and the third parallel arc interruption operation in which at least one of the following (1) to (3) is performed is executed, so that the parallel arc discharge can be promptly extinguished without providing a breaker.
(1) Interrupting to output power to the bidirectional converter portion 5 by the power-storage-side relay portion included in the power storage module 6.
(2) Setting the switching element Q7 to the ON state.
(3) Opening the system relay portions 27a and 27b to interrupt conduction of power between the full-bridge circuit side and the system-side connection terminals 22 and 23 side, and setting the switching elements Q3 and Q5 and/or the switching elements Q4 and Q6 to the ON state.

With the power supply system 1 of the present embodiment, even in a case where the series arc discharge occurs in a portion closer to the power storage module 6 than to the bidirectional converter portion 5, the third series arc interruption operation in which the following (4) and/or (5) is performed is executed, so that the series arc discharge can be promptly extinguished without providing a breaker.
(4) Interrupting to output power to the bidirectional converter portion 5 by the power-storage-side interrupter included in the power storage module 6.
(5) Setting the switching elements Q7 and Q8 to the OFF state.

With the power supply system 1 of the present embodiment, in the third series arc interruption operation, in a case where the series arc discharge occurs in a portion closer to the power storage module 6 than to the bidirectional converter portion 5; when the voltage Vc1 of the inverter portion 12 exceeds the voltage Vbatt of the power storage module 6, at least the above (4) or the above (5) is performed; and when the voltage Vc1 of the inverter portion 12 is equal to or less than the voltage Vbatt of the power storage module 6, a combination of the above (4) or the above (5) and the following (6) is performed; so that the series arc discharge can be more safely extinguished even in a case where the voltage Vc1 of the inverter portion 12 is equal to or less than the voltage Vbatt of the power storage module 6.

(6) Setting the switching elements Q3 and Q4 and/or the switching elements Q5 and Q6 to the OFF state, or opening the system relay portions 27a and 27b, so that to interrupt the supply of power to the system-side connection terminals 22 and 23.

With the power supply system 1 of the present embodiment, even in a case where the parallel arc discharge occurs in a portion between the bidirectional converter portion 5 and the power conversion device 3, interrupting the conduction of power between the full-bridge circuit side and the system-side connection terminals 22 and 23 side by opening the system relay portions 27a and 27b, together with executing the second parallel arc interruption operation in which at least one of the following (7) and (8) is performed, can make the parallel arc discharge to be promptly extinguished without providing a breaker.
(7) Setting the switching elements Q3 and Q5 and/or the switching elements Q4 and Q6 to the ON state, and setting the switching elements Q7 and Q8 to the OFF state.
(8) Setting the switching elements Q7 and Q8 to the ON state.

With the power supply system 1 of the present embodiment, in the second parallel arc interruption operation, in a case where the power storage module 6 includes the power-storage-side relay portion, the distribution of power with the bidirectional converter portion 5 is interrupted, and therefore, the arc discharge can be extinguished more safely.

With the power supply system 1 of the present embodiment, even in a case where the series arc discharge occurs in a portion between the bidirectional converter portion 5 and the power conversion device 3, the second series arc interruption operation in which the following (9) and/or (10) is performed is executed, so that the series arc discharge can be promptly extinguished without providing a breaker.
(9) Interrupting to output power to the bidirectional converter portion 5 by the power-storage-side relay portion included in the power storage module 6, and setting the switching element Q7 and/or the switching element Q8 to the OFF state.
(10) Setting the switching element Q7 and the switching element Q8 to the OFF state.

With the power supply system 1 of the present embodiment, in the second series arc interruption operation; when the voltage Vc1 of the inverter portion 12 exceeds the voltage Vbatt of the power storage module 6, at least the above (9) or the above (10) is performed; and when the voltage Vc1 of the inverter portion 12 is equal to or less than the voltage Vbatt of the power storage module 6, at least a combination of the above (9) or the above (10) and the following (11) is performed; so that the series arc discharge can be more safely extinguished even in a case where the voltage Vc1 of the inverter portion 12 exceeds the voltage Vbatt of the power storage module 6.

(11) Interrupting the supply of power to the system-side connection terminals 22 and 23, by setting the switching elements Q3 and Q4 and/or the switching elements Q5 and Q6 to the OFF state, or by opening the system relay portions 27a and 27b.

With the power supply system 1 of the present embodiment, even in a case where the parallel arc discharge occurs in a portion closer to the power generation module 2a (2b) than to the power conversion device 3, the first parallel arc interruption operation (power-generation-side parallel arc interruption operation) in which the switching element Q1a (Q1b) is set to the ON state is executed, so that the parallel arc discharge can be promptly extinguished without providing a breaker.

With the power supply system 1 of the present embodiment, even in a case where the series arc discharge occurs in a portion closer to the power generation module 2a (2b) than to the power conversion device 3, the first series arc interruption operation (power-generation-side series arc interruption operation) in which the switching element Q1a (Q1b) is set to the OFF state is executed, so that the series arc discharge can be promptly extinguished without providing a breaker.

With the power supply system 1 of the present embodiment, in the first series arc interruption operation, in a case where the voltage Vc1 of the inverter portion 12 is less than the voltage Vpv of the power generation module 2a (2b), the switching elements Q3 and Q4 and/or the switching elements Q5 and Q6 are set to the OFF state, and the switching element Q8 is set to the OFF state, so that the arc discharge can be more safely extinguished.

With the power supply system 1 of the present embodiment, in a case where the voltage Vc1 of inverter portion 12 is less than the voltage Vpv of the power generation module 2a (2b), and in a case where the power storage module 6 includes the power-storage-side relay portion, the power-storage-side relay portion is opened, and the switching element Q7 or the switching element Q8 is set to the OFF state, so that the arc discharge can be extinguished more safely.

Subsequently, a power supply system 201 of a second embodiment of the present invention will be described. Note that the same configurations as those of the power supply system 1 of the first embodiment are denoted by the same reference numerals, and the description thereof will be omitted. The same applies hereinafter.

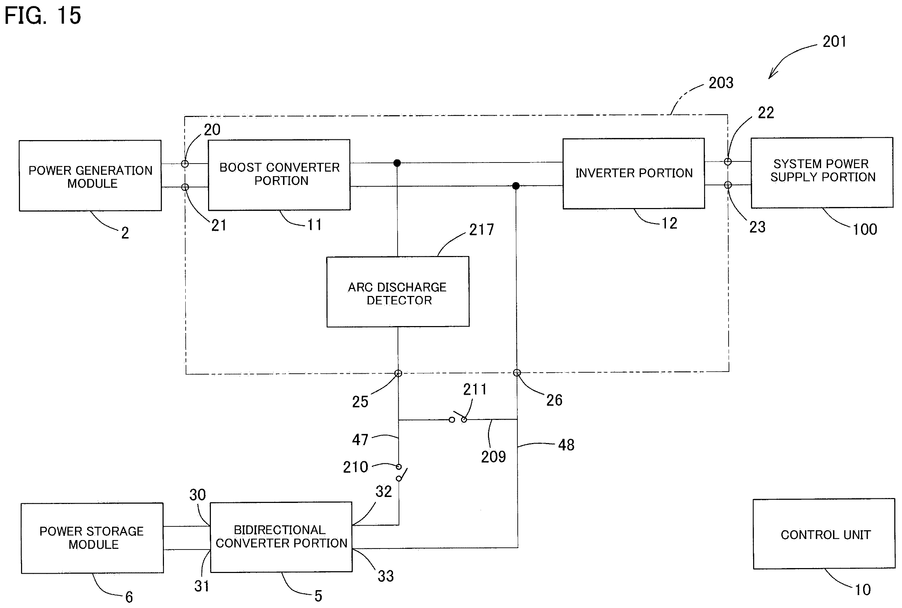

As illustrated in Fig. 15, the power supply system 201 of the second embodiment includes the power generation module 2, a power conversion device 203, the bidirectional converter portion 5, the power storage module 6, the positive-electrode-side wiring portion 47, the negative-electrode-side wiring portion 48, a short-circuit wiring portion 209, a first relay portion 210 (series arc interrupter), a second relay portion 211 (parallel arc short-circuit portion), and the control unit 10, and the system power supply portion 100 can be connected to the power conversion device 203.

Then, the power supply system 201 of the second embodiment is, as needed, provided with the first arc detectors 7a and 7b, the second arc detector 8, and the third arc detector 9, so that a driving operation similar to that of the power supply system 1 of the first embodiment can be performed. However, in the following description, these are omitted, and a case where the second series arc interruption operation and the second parallel arc interruption operation in the power supply system 1 of the first embodiment are executed by the relay portions 210 and 211 will be described.

Similarly to the power supply system 1 of the first embodiment, the power supply system 201 can execute a generated power supply mode, a generated power charging mode, a stored power supply mode, and a system power charging mode.

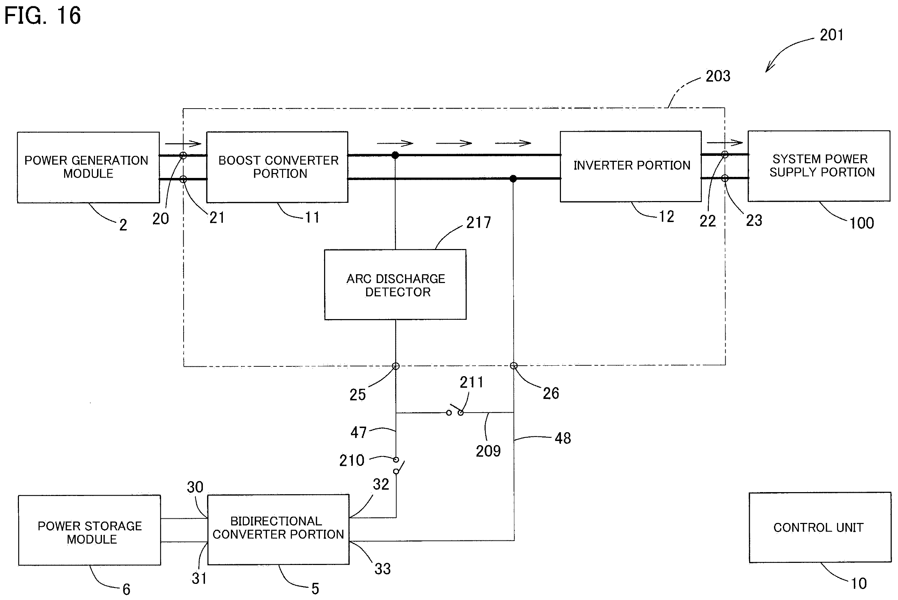

In the generated power supply mode, as illustrated in Fig. 16, both the first relay portion 210 and the second relay portion 211 are in an open state.

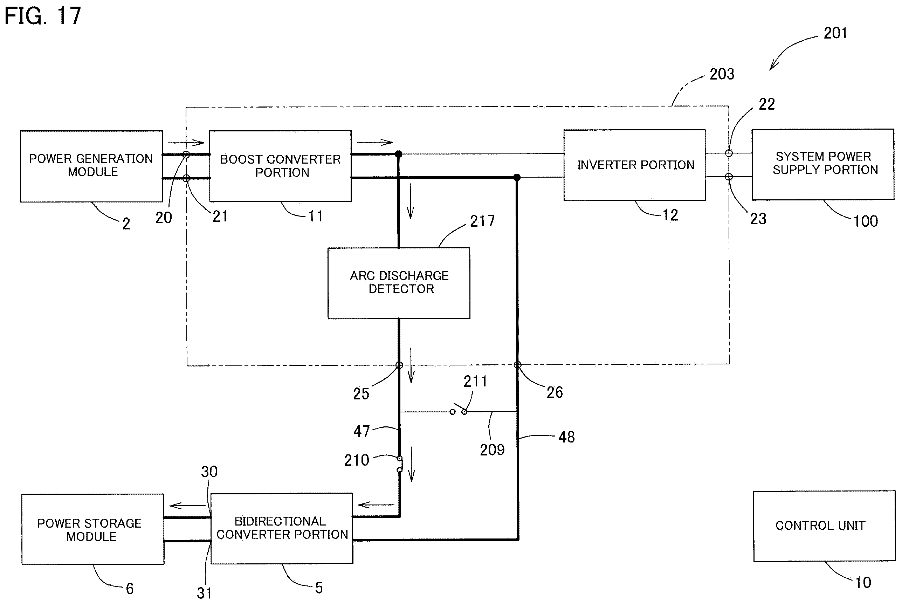

In the generated power charging mode, as illustrated in Fig. 17, the first relay portion 210 is in a closed state, and the second relay portion 211 is in an open state.

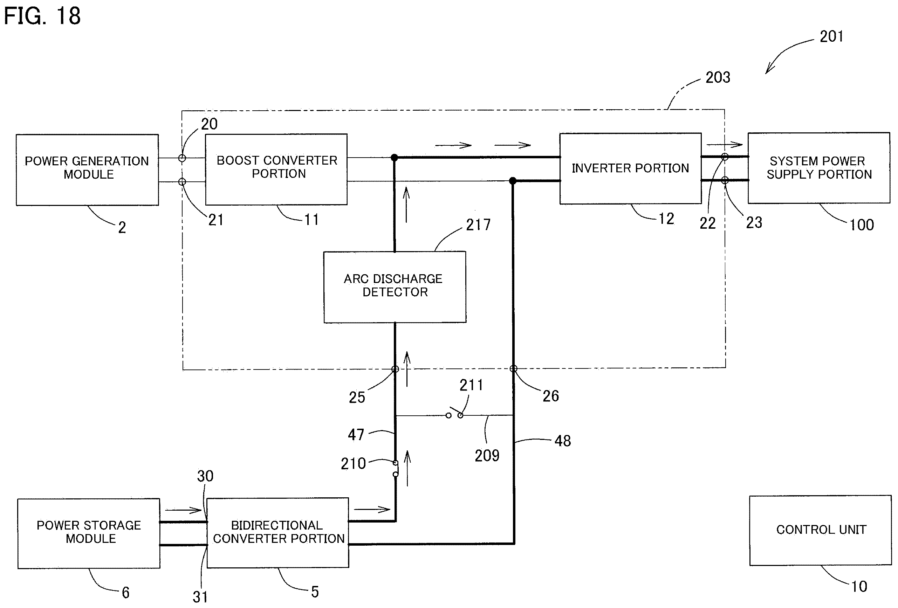

In the stored power supply mode, as illustrated in Fig. 18, the first relay portion 210 is in a closed state, and the second relay portion 211 is in an open state.

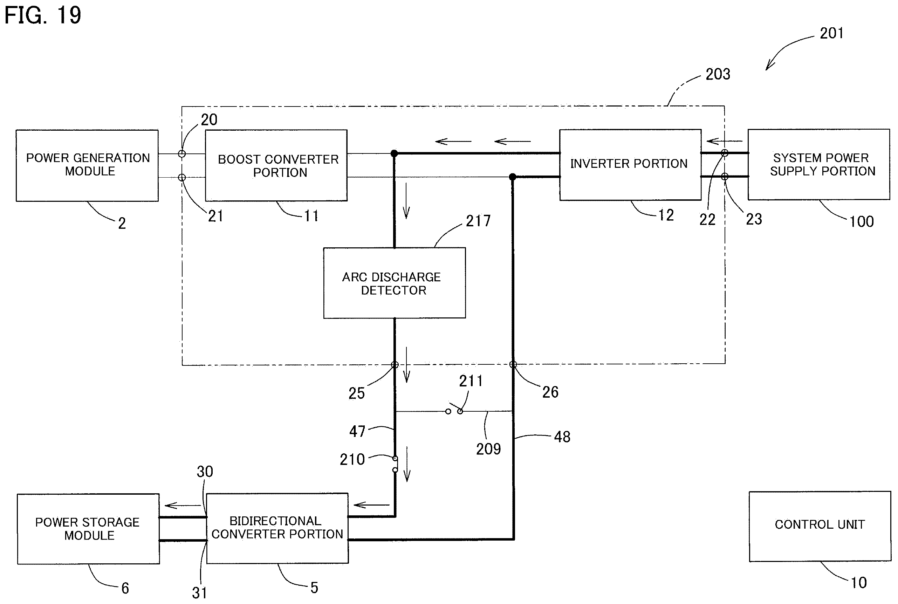

In the system power charging mode, as illustrated in Fig. 19, the first relay portion 210 is in a closed state, and the second relay portion 211 is in an open state.

### (Power Conversion Device 203)

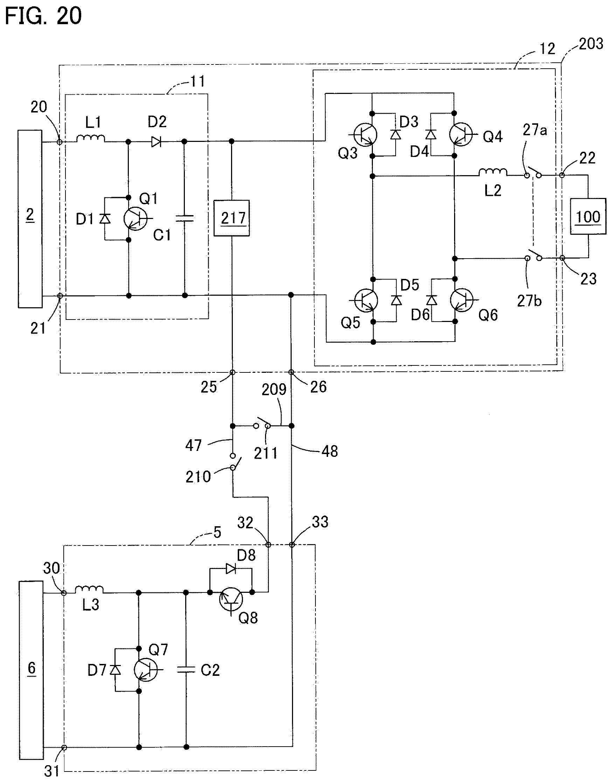

As illustrated in Fig. 20, the power conversion device 203 includes the boost converter portion 11, the inverter portion 12, an arc discharge detector 217, the positive-electrode-side input terminal 20, the negative-electrode-side input terminal 21, the system-side connection terminals 22 and 23, and the converter-side connection terminals 25 and 26.

### (Arc Discharge detector 217)

The arc discharge detector 217 is a part that is provided between the output side of the boost converter portion 11 in the generated power supply mode and the generated power charging mode and the converter-side connection terminal 25, and detects arc discharge occurring in a portion between the boost converter portion 11 and the bidirectional converter portion 5.

In addition, the arc discharge detector 217 is also a part that is provided between the input side of the inverter portion 12 in the stored power supply mode (output side of the inverter portion 12 in the system power charging mode) and the converter-side connection terminal 25, and detects arc discharge occurring in a portion between the inverter portion 12 and the bidirectional converter portion 5.

That is, the arc discharge detector 217 is provided in the middle of a branch wiring line that is branched from the middle of a wiring line connecting the boost converter portion 11 and the inverter portion 12 and is connected to the converter-side connection terminal 25.

The arc discharge detector 217 of the present embodiment is a high-frequency detection device, and can analyze high-frequency noise (high-frequency component) generated when arc discharge occurs, and detect the arc discharge from the high-frequency noise.

### (Short-Circuit Wiring Portion 209)

The short-circuit wiring portion 209 is a connection wiring line that connects the positive-electrode-side wiring portion 47 and the negative-electrode-side wiring portion 48, and is a part that makes the positive-electrode-side wiring portion 47 and the negative-electrode-side wiring portion 48 conductive.

### (First Relay Portion 210)

The first relay portion 210 is a relay that is provided in the middle of the positive-electrode-side wiring portion 47 and automatically opens and closes the switch, and is a part that enables and interrupts the distribution of power between the converter-side connection terminal 25 side and the conversion-side connection terminal 32 side by switching on and off.

The first relay portion 210 of the present embodiment is provided closer to the bidirectional converter portion 5 side than to the connection portion between the positive-electrode-side wiring portion 47 and the short-circuit wiring portion 209.

### (Second Relay Portion 211)

The second relay portion 211 is a relay that is provided in the middle of the short-circuit wiring portion 209 and automatically opens and closes the switch, and is a part that enables and interrupts, by switching on and off, the distribution of power between the positive-electrode-side wiring portion 47 side and the negative-electrode-side wiring portion 48 side.

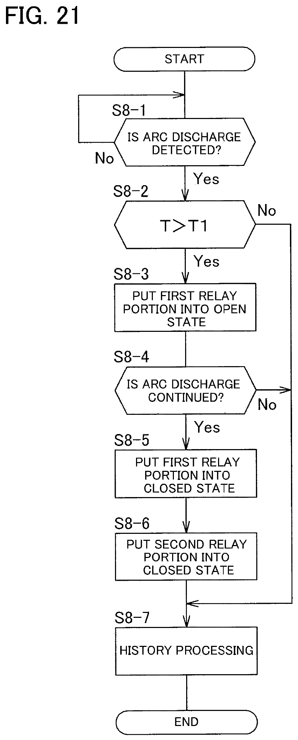

Next, an arc interruption operation of the power supply system 201 will be described with reference to a flowchart of Fig. 21.

The arc interruption operation of the power supply system 201 is executed in parallel with the above-described various modes, and is an operation of extinguishing the arc discharge when the arc discharge detector 217 detects the arc discharge.

The arc interruption operation of the power supply system 201 is performed without distinguishing, by the arc discharge detector 217, between the parallel arc discharge and the series arc discharge, and corresponds to the second series arc interruption operation and the second parallel arc interruption operation in the power supply system 1 of the first embodiment.

Specifically, as illustrated in Fig. 21, in the arc interruption operation, first, the arc discharge detector 217 monitors the arc discharge by the high-frequency noise, and in a case where the arc discharge is detected (Yes in step S8-1), it is determined whether or not a time T during which the arc discharge occurs (a time during which the arc discharge continues after the arc discharge occurs) exceeds a time threshold value T1 (step S8-2).

At this time, the time threshold value T1 is not particularly limited, but is preferably 2 seconds or more and preferably 5 seconds or less.

The time threshold value T1 of the present embodiment is set to 2.5 seconds.

In a case where the time T during which the arc discharge occurs exceeds the time threshold value T1, that is, in a case where the arc discharge is not extinguished even after the time threshold value T1 has elapsed since the occurrence of the arc discharge (Yes in step S8-2), the first relay portion 210 is put into the open state to interrupt the distribution of power between the converter-side connection terminal 25 side and the conversion-side connection terminal 32 side (step S8-3), and it is determined whether or not the arc discharge is continuously detected by the arc discharge detector 217 (step S8-4).

In a case where the arc discharge is continuously detected by the arc discharge detector 217 (Yes in step S8-4), it is determined that parallel arc discharge occurs, the first relay portion 210 is put into the closed state (step S8-5), the second relay portion 211 is put into the closed state so that the positive-electrode-side wiring portion 47 and the negative-electrode-side wiring portion 48 are made conductive and short-circuited (step S8-6), the control unit 10 performs history processing of creating history data such as an occurrence time and the number of occurrences of the arc discharge and the type of the arc discharge, transmitting the history data to a computer or the like of a manager via a network such as the Internet, and storing the history data (step S8-7).

In step S8-4, in a case where the arc discharge is not continuously detected by the arc discharge detector 217, it is determined that the arc discharge is series arc discharge and the arc discharge is extinguished, and the processing proceeds to step S8-7.

With the power supply system 201 of the present embodiment, when the arc discharge is detected in a portion between the inverter portion 12 of the power conversion device 203 and the bidirectional converter portion 5 and/or a portion between the boost converter portion 11 of the power conversion device 203 and the bidirectional converter portion 5, the conduction between the inverter portion 12 and the bidirectional converter portion 5 and the conduction between the boost converter portion 11 and the bidirectional converter portion 5 are interrupted by the first relay portion 210. Therefore, in a case where the series arc discharge occurs in a portion between the power conversion device 203 and the bidirectional converter portion 5, the series arc discharge can be promptly extinguished.

With the power supply system 201 of the present embodiment, when the arc discharge detector 217 continuously detects the arc discharge after the first relay portion 210 interrupts the conduction of power between the boost converter portion 11 and the bidirectional converter portion 5 and the conduction between the boost converter portion 11 and the bidirectional converter portion 5, the positive-electrode-side wiring portion 47 and the negative-electrode-side wiring portion 48 are made conductive by the second relay portion 211 and the short-circuit wiring portion 209, and therefore, even in a case where the parallel arc discharge occurs in a portion between the power conversion device 203 and the bidirectional converter portion 5, the arc discharge can be promptly extinguished.

With the power supply system 201 of the present embodiment, it is possible to cope with the series arc discharge and the parallel arc discharge without modifying the inside of the power conversion device 203.

In the above embodiment, the power generation modules 2a and 2b are both solar cell modules, but the present invention is not limited thereto. The power generation modules 2a and 2b may be different types of power generation modules. For example, the power generation module 2a may be a solar cell module, and the power generation module 2b may be a fuel cell module.

In the embodiments described above, the case where the power supply systems 1 and 201 include one or two power generation modules 2 has been described, but the present invention is not limited thereto. The power supply systems 1 and 201 may include three or more power generation modules 2. In that case, it is preferable to provide the boost converter portion 11 corresponding to each power generation module 2.

In the embodiments described above, the case where the power supply systems 1 and 201 include one power storage module 6 has been described, but the present invention is not limited thereto. The power supply systems 1 and 201 may include two or more power storage modules 6. In this case, it is preferable to provide the bidirectional converter portion 5 corresponding to each power storage module 6.

In the first embodiment described above, in step S2-3 of the first series arc interruption operation, the switching elements Q3 and Q4 and/or the switching elements Q5 and Q6 are set to the OFF state in order to interrupt the flow of the power to the system-side connection terminals 22 and 23 side, but the present invention is not limited thereto. Alternatively or additionally, the system relay portions 27a and 27b may be opened to interrupt the distribution of power.

Similarly, in step S4-6 of the second series arc interruption operation, the switching elements Q3 and Q4 and/or the switching elements Q5 and Q6 are set to the OFF state, but the system relay portions 27a and 27b may be opened alternatively or additionally.

Similarly, in step S6-5 of the third series arc interruption operation, the switching elements Q3 and Q4 and/or the switching elements Q5 and Q6 are set to the OFF state, but the system relay portions 27a and 27b may be opened alternatively or additionally.

In the embodiment described above, the inverter portion 12 performs conversion between DC power and AC power by the full-bridge circuit, but the present invention is not limited thereto. The inverter portion 12 may perform conversion between DC power and AC power by a half-bridge circuit.

In the embodiment described above, the single control unit 10 performs the PWM control on each of the switching elements Q1a, Q1b, and Q3 to Q8, but the present invention is not limited thereto. A plurality of control units 10 may perform PWM control on each of the switching elements Q1a, Q1b, and Q3 to Q8 individually or in each group.

In the first embodiment described above, in each of the arc detectors 7a, 7b, 8, and 9, the series arc detector that detects series arc discharge and the parallel arc detector that detects parallel arc discharge are integrated, but the present invention is not limited thereto. In each of the arc detectors 7a, 7b, 8, and 9, the series arc detector that detects series arc discharge and the parallel arc detector that detects parallel arc discharge may be separated. That is, each of the arc detectors 7a, 7b, 8, and 9 may be configured by a plurality of arc detectors.

In the embodiment described above, in the power conversion devices 3 and 203, the boost converter portion 11 and the inverter portion 12 are provided in the same casing, but the present invention is not limited thereto. The boost converter portion 11 and the inverter portion 12 may be individually provided in different casings.

In the embodiment described above, the power conversion device 3 is separate from the bidirectional converter portion 5, but the present invention is not limited thereto. The power conversion device 3 may be integrated with the bidirectional converter portion 5. That is, the boost converter portions 11a and 11b, the inverter portion 12, and the bidirectional converter portion 5 may be provided in the same casing.

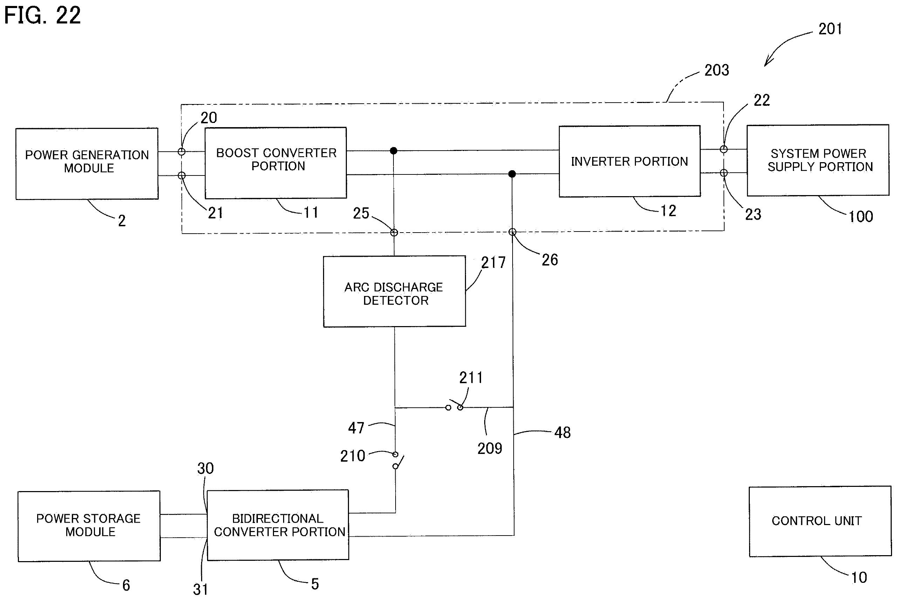

In the second embodiment described above, the arc discharge detector 217 is provided inside the power conversion device 203, but the present invention is not limited thereto. The arc discharge detector 217 may be provided outside the power conversion device 203. For example, as illustrated in Fig. 22, the arc discharge detector 217 may be provided in the positive-electrode-side wiring portion 47.

In the second embodiment described above, the arc discharge detector 217 detects the arc discharge without distinguishing between the series arc discharge and the parallel arc discharge, and the series arc discharge and the parallel arc discharge are distinguished depending on whether or not the arc discharge is detected after putting the first relay portion 210 into the closed state. However, the present invention is not limited thereto. The series arc discharge and the parallel arc discharge may be directly distinguished by arc discharge detector 217 (parallel arc discharge detector).

In this case, since it can be determined whether the arc discharge is series arc discharge or parallel arc discharge, each of relay portions 210 and 211 may be controlled depending on the type of arc discharge. That is, in a case where the arc discharge is series arc discharge, the first relay portion 210 may be put into the closed state, and in a case where the arc discharge is parallel arc discharge, the second relay portion 211 may be put into the closed state.

In the embodiments described above, each component member can be freely replaced or added between the embodiments as long as it is included in the technical scope of the present invention.

### EXPLANATION OF REFERENCE SIGNS

1, 201: power supply system
2: power generation module
3, 203: power conversion device
5: bidirectional converter portion
6: power storage module
7: first arc detector (power-generation-side series arc detector, power-generation-side parallel arc detector)
8: second arc detector (arc discharge detector, second parallel arc detector, second series arc detector)
9: third arc detector (arc discharge detector, parallel arc detector, series arc detector)
12: inverter portion
22, 23: system-side connection terminal
25, 26: converter-side connection terminal
27a, 27b: system relay portion (inverter-side interrupter, system interrupter)
30, 31: power-storage-side connection terminal (power-storage-side connection part)
32, 33: conversion-side connection terminal (conversion-side connection part)
100: system power supply portion
210: first relay portion (series arc interrupter)
211: second relay portion (parallel arc short-circuit portion)
217: arc discharge detector (parallel arc discharge detector)
D2a(D2b): diode portion (power-generation-side rectifying portion)
D7: diode portion (first rectifying portion)
D8: diode portion (second rectifying portion)
L1a(L1b): reactor portion (power-generation-side reactor portion)
L3: reactor portion
Q1: switching element (power-generation-side switching element)
Q3: switching element (third switching element, inverter-side interrupter)
Q4: switching element (fourth switching element, inverter-side interrupter)
Q5: switching element (fifth switching element, inverter-side interrupter)
Q6: switching element (sixth switching element, inverter-side interrupter)
Q7: switching element (first switching element)
Q8: switching element (second switching element)

## Claims

1. A power supply system comprising:
a power storage module;
a power conversion device;
a bidirectional converter portion; and
an arc discharge detector,
wherein the power storage module has a secondary battery, and is connected to the power conversion device via the bidirectional converter portion,
the arc discharge detector detects arc discharge in a portion closer to the power storage module than to the power conversion device, and
when the arc discharge detector detects the arc discharge, an arc interruption operation of interrupting conduction of power between the power conversion device and the secondary battery is executed.

2. The power supply system according to claim 1,
wherein the bidirectional converter portion has a power-storage-side connection part electrically connected to the power storage module, and a conversion-side connection part electrically connected to the power conversion device,
the bidirectional converter portion has a step-down circuit in which the power-storage-side connection part, a reactor portion, a second switching element, and the conversion-side connection part are connected in series, and a first rectifying portion is connected in parallel to the reactor portion and the power storage module; and a boost circuit in which the power-storage-side connection part, the reactor portion, a second rectifying portion, and the conversion-side connection part are connected in series, and a first switching element is connected in parallel to the reactor portion and the power storage module,
the bidirectional converter portion is capable of executing a step-down operation that steps down an input voltage from the power conversion device by putting the first switching element into an OFF state and switching between an ON state and an OFF state of the second switching element, and outputs power to the power storage module; and a boost operation that boosts the input voltage from the power storage module by putting the second switching element into the OFF state and switching between the ON state and the OFF state of the first switching element, and outputs power to the power conversion device,
the power supply system further includes a series arc detector that detects series arc discharge in a portion closer to the power storage module than to the bidirectional converter portion, and
when the series arc detector detects series arc discharge, a series arc interruption operation in which following (A) and/or (B) is performed is executed.
(A) Interrupting to input and to output power to and from the bidirectional converter portion by a power-storage-side interrupter included in the power storage module.
(B) Keeping the first switching element and the second switching element in the OFF state or putting them into the OFF state and then maintaining.

3. The power supply system according to claim 2,
wherein the power conversion device has a system-side connection terminal connectable to a system power supply portion, and an inverter portion having an inverter-side interrupter that is capable of interrupting supply of power to the system-side connection terminal side, and
the series arc interruption operation performs, in a case where a voltage of the inverter portion exceeds a voltage of the power storage module, at least the (A) or the (B); and performs, in a case where the voltage of the inverter portion is equal to or less than the voltage of the power storage module, at least a combination of the (A) or the (B) and following (C).
(C) Interrupting supply of power to the system-side connection terminal side by the inverter-side interrupter.

4. The power supply system according to any one of claims 1 to 3,
wherein the power conversion device has an inverter portion, and a system-side connection terminal connectable to a system power supply portion,
the inverter portion includes a third switching element, a fourth switching element, a fifth switching element, and a sixth switching element; and is provided with a full-bridge circuit in which the third switching element and the sixth switching element, and the fourth switching element and the fifth switching element are respectively arranged diagonally,
the inverter portion includes a system interrupter that interrupts distribution of power between the full-bridge circuit side and the system-side connection terminal side,
the bidirectional converter portion has a power-storage-side connection part electrically connected to the power storage module, and a conversion-side connection part electrically connected to the power conversion device,
the bidirectional converter portion has a step-down circuit in which the power-storage-side connection part, a reactor portion, a second switching element, and the conversion-side connection part are connected in series, and a first rectifying portion is connected in parallel to the reactor portion and the power storage module; and a boost circuit in which the power-storage-side connection part, the reactor portion, a second rectifying portion, and the conversion-side connection part are connected in series, and a first switching element is connected in parallel to the reactor portion and the power storage module,
the bidirectional converter portion is capable of executing
a step-down operation that steps down an input voltage from the power conversion device by putting the first switching element into an OFF state and switching between an ON state and an OFF state of the second switching element, and outputs power to the power storage module; and
a boost operation that boosts the input voltage from the power storage module by putting the second switching element into the OFF state and switching between the ON state and the OFF state of the first switching element, and outputs power to the power conversion device,
the power supply system further includes a parallel arc detector that detects parallel arc discharge in a portion closer to the power storage module than to the bidirectional converter portion, and
when the parallel arc detector detects parallel arc discharge, a parallel arc interruption operation is executed, in the parallel arc interruption operation, the second switching element is kept in an OFF state or is put into the OFF state and then maintained, and at least one of following (D) to (F) is performed.
(D) Interrupting to input and to output power to and from the bidirectional converter portion by a power-storage-side interrupter included in the power storage module.
(E) Keeping the first switching element in the ON state or putting it into the ON state and then maintaining.
(F) Interrupting conduction of power between the full-bridge circuit side and the system-side connection terminal side by the system interrupter, and keeping the third switching element and the fifth switching element and/or the fourth switching element and the sixth switching element in the ON state or putting them into the ON state and then maintaining.

5. The power supply system according to any one of claims 2 to 4, further comprising:
a second parallel arc detector that detects parallel arc discharge in a portion between the bidirectional converter portion and the power conversion device,
wherein the power conversion device has an inverter portion, and a system-side connection terminal connectable to a system power supply portion,
the inverter portion includes a third switching element, a fourth switching element, a fifth switching element, and a sixth switching element; and is provided with a full-bridge circuit in which the third switching element and the sixth switching element, and the fourth switching element and the fifth switching element are respectively arranged diagonally,
the inverter portion includes a system interrupter that interrupts distribution of power between the full-bridge circuit side and the system-side connection terminal side, and
when the second parallel arc detector detects parallel arc discharge, conduction of power between the full-bridge circuit side and the system-side connection terminal side is interrupted by the system interrupter, and a second parallel arc interruption operation in which at least one of following (G) and (H) is performed is executed.
(G) Keeping the third switching element and the fifth switching element and/or the fourth switching element and the sixth switching element in the ON state or putting them into the ON state and then maintaining and keeping the first switching element and the second switching element in the OFF state or putting them into the OFF state and then maintaining.
(H) Keeping the first switching element and the second switching element in the ON state or putting them into the ON state and then maintaining.

6. The power supply system according to claim 5, wherein in the second parallel arc interruption operation, distribution of power with respect to the bidirectional converter portion is interrupted by a power-storage-side interrupter included in the power storage module.

7. The power supply system according to any one of claims 1 to 6,
wherein the bidirectional converter portion has a power-storage-side connection part electrically connected to the power storage module, and a conversion-side connection part electrically connected to the power conversion device,
the bidirectional converter portion has a step-down circuit in which the power-storage-side connection part, a reactor portion, a second switching element, and the conversion-side connection part are connected in series, and a first rectifying portion is connected in parallel to the reactor portion and the power storage module; and a boost circuit in which the power-storage-side connection part, the reactor portion, a second rectifying portion, and the conversion-side connection part are connected in series, and a first switching element is connected in parallel to the reactor portion and the power storage module,
the bidirectional converter portion is capable of executing a step-down operation that steps down an input voltage from the power conversion device by putting the first switching element into an OFF state and switching between an ON state and an OFF state of the second switching element, and outputs power to the power storage module; and a boost operation that boosts the input voltage from the power storage module by putting the second switching element into the OFF state and switching between the ON state and the OFF state of the first switching element, and outputs power to the power conversion device,
the power supply system further includes a second series arc detector that detects series arc discharge in a portion between the bidirectional converter portion and the power conversion device, and
when the second series arc detector detects series arc discharge, a second series arc interruption operation in which following (I) and/or (J) is performed is executed.
(I) Interrupting to input and to output power to and from the bidirectional converter portion by a power-storage-side interrupter included in the power storage module, and keeping the first switching element and/or the second switching element in the OFF state or put ting it into the OFF state and then maintaining.
(J) Keeping the first switching element and the second switching element in the OFF state or putting them into the OFF state and then maintaining.

8. The power supply system according to claim 7,
wherein the power conversion device has a system-side connection terminal connectable to a system power supply portion, and an inverter portion having an inverter-side interrupter that is capable of interrupting supply of power to the system-side connection terminal side, and
the second series arc interruption operation performs at least the (I) or the (J) in a case where a voltage of the inverter portion exceeds a voltage of the power storage module, and performs at least a combination of the (I) or the (J) and following (K) in a case where the voltage of the inverter portion is equal to or less than the voltage of the power storage module.
(K) Interrupting supply of power to the system-side connection terminal side by the inverter-side interrupter.

9. The power supply system according to any one of claims 1 to 8, further comprising:
a power generation module; and
a power-generation-side series arc detector,
wherein the power conversion device has a boost converter portion,
the boost converter portion has a power-generation-side boost circuit in which a power-generation-side reactor portion and a power-generation-side switching element are connected in series, and is capable of executing a power-generation-side boost operation of boosting an input voltage from the power generation module by switching between an ON state and an OFF state of the power-generation-side switching element and outputting power to the bidirectional converter portion,
the boost converter portion has a power-generation-side rectifying portion that allows a flow of a current from the power-generation-side boost circuit side to the bidirectional converter portion side and interrupts a flow of a current from the bidirectional converter portion side to the power-generation-side boost circuit side,
the power-generation-side series arc detector detects series arc discharge in a portion closer to the power generation module than to the power conversion device, and
when the power-generation-side series arc detector detects series arc discharge, a power-generation-side series arc interruption operation in which the power-generation-side switching element is kept in the OFF state or is put into the OFF state and then maintained is executed.

10. The power supply system according to any one of claims 1 to 9, further comprising:
a power generation module; and
a power-generation-side parallel arc detector,
wherein the power conversion device has a boost converter portion,
the boost converter portion has a power-generation-side boost circuit in which a power-generation-side reactor portion and a power-generation-side switching element are connected in series, and is capable of executing a power-generation-side boost operation of boosting an input voltage from the power generation module by switching between an ON state and an OFF state of the power-generation-side switching element and outputting power to the bidirectional converter portion,
the power-generation-side parallel arc detector detects parallel arc discharge in a portion closer to the power generation module than to the power conversion device, and
when the power-generation-side parallel arc detector detects parallel arc discharge, a power-generation-side parallel arc interruption operation in which the power-generation-side switching element is kept in the ON state or is put into the ON state and then maintained is executed.

11. The power supply system according to claim 1, further comprising:
a series arc interrupter,
wherein the series arc interrupter is provided between the power conversion device and the bidirectional converter portion, and
when the arc discharge detector detects arc discharge, the series arc interrupter interrupts conduction of power between the power conversion device and the bidirectional converter portion.

12. The power supply system according to claim 11, further comprising:
a positive-electrode-side wiring portion;
a negative-electrode-side wiring portion; and
a parallel arc short-circuit portion,
wherein the bidirectional converter portion is connected to the power conversion device via the positive-electrode-side wiring portion and the negative-electrode-side wiring portion, and
the parallel arc short-circuit portion makes, after the series arc interrupter interrupts the conduction of power between the power conversion device and the bidirectional converter portion, and when the arc discharge detector detects arc discharge, the positive-electrode-side wiring portion and the negative-electrode-side wiring portion conductive.

13. The power supply system according to claim 11 or 12, wherein the series arc interrupter is provided outside the power conversion device.

14. The power supply system according to claim 12, wherein the parallel arc short-circuit portion is provided outside the power conversion device.

15. A power supply system comprising:
a power storage module;
a power conversion device; and
a bidirectional converter portion,
wherein the power storage module is connected to the power conversion device via the bidirectional converter portion,
the power conversion device has an inverter portion, and a system-side connection terminal connectable to a system power supply portion,
the inverter portion includes a third switching element, a fourth switching element, a fifth switching element, and a sixth switching element; and is provided with a full-bridge circuit in which the third switching element and the sixth switching element, and the fourth switching element and the fifth switching element are respectively arranged diagonally,
the inverter portion includes a system interrupter that interrupts distribution of power between the full-bridge circuit side and the system-side connection terminal side,
the bidirectional converter portion has a power-storage-side connection part electrically connected to the power storage module, and a conversion-side connection part electrically connected to the power conversion device,
the bidirectional converter portion has a step-down circuit in which the power-storage-side connection part, a reactor portion, a second switching element, and the conversion-side connection part are connected in series, and a first rectifying portion is connected in parallel to the reactor portion and the power storage module; and a boost circuit in which the power-storage-side connection part, the reactor portion, a second rectifying portion, and the conversion-side connection part are connected in series, and a first switching element is connected in parallel to the reactor portion and the power storage module,
the bidirectional converter portion is capable of executing a step-down operation that steps down an input voltage from the power conversion device by putting the first switching element into an OFF state and switching between an ON state and an OFF state of the second switching element, and outputs power to the power storage module; and a boost operation that boosts the input voltage from the power storage module by putting the second switching element into the OFF state and switching between the ON state and the OFF state of the first switching element, and outputs power to the power conversion device,
the power supply system further includes a parallel arc detector that detects parallel arc discharge in a portion closer to the power storage module than to the bidirectional converter portion, and
when the parallel arc detector detects parallel arc discharge, the second switching element is kept in an OFF state or is put into the OFF state and then maintained, and a parallel arc interruption operation in which at least one of following (D) to (F) is performed is executed.
(D) Interrupting to input and to output power to and from the bidirectional converter portion by a power-storage-side interrupter included in the power storage module.
(E) Keeping the first switching element in the ON state or putting it into the ON state and then maintaining.
(F) Interrupting conduction of power between the full-bridge circuit side and the system-side connection terminal side by the system interrupter, and keeping the third switching element and the fifth switching element and/or the fourth switching element and the sixth switching element in the ON state or putting them into the ON state and then maintaining.
